# EUROPEAN PATENT APPLICATION

(11) **EP 4 514 107 A1**
(43) Date of publication of application: **26.02.2025**
(21) Application number: 24195098.9
(22) Date of filing: 19.08.2024
(51) Int. Cl.: H10K 59/122, H10K 59/40

(54) **DISPLAY DEVICE AND METHOD OF PROVIDING THE SAME**

(30) Priority: 22.08.2023 KR 20230109688
(71) Applicant: Samsung Display Co., Ltd., Gyeonggi-Do (KR)
(72) Inventor: SUNG, Woo Yong, Yongin-si, Gyeonggi-do (KR); SONG, Seungyong, Yongin-si, Gyeonggi-do (KR); YANG, Hee Jun, Yongin-si, Gyeonggi-Do (KR); LEE, Jeongseok, Yongin-si, Gyeonggi-Do (KR)
(74) Representative: Gulde & Partner

(57) **Abstract**

A display device includes a pixel defining layer (PDL) including a light emitting opening (OP-E) defined therein, a barrier wall layer (PW) on the pixel defining layer (PDL) and including barrier walls spaced apart from each other and defining a barrier wall opening (OP-P) of the barrier wall layer (PW) which is between the barrier walls, the barrier wall opening (OP-P) overlapping the light emitting opening (OP-E) of the pixel defining layer (PDL), a light emitting element (ED) overlapping the light emitting opening (OP-E) of the pixel defining layer (PDL) and a spacer (SPC) which is on a barrier wall among the barrier walls (PW) and spaced apart from the light emitting opening (OP-E) and the barrier wall opening (OP-P). The barrier wall which has the spacer (SPC) thereon defines a blocking opening (OP-A1) of the barrier wall which surrounds the spacer (SPC).

## Description

### BACKGROUND

### (1) Field

Embodiments of the present disclosure described herein relate to a display device and a method of providing the same. More particularly, the present disclosure relates to a display device including a spacer and a method for providing the display device.

### (2) Description of the Related Art

A display device, such as a television, a monitor, a smart phone, a tablet computer, or the like, which provides an image to a user includes a display panel that displays an image. Various display panels, such as a liquid crystal display panel, an organic light emitting display panel, an electro wetting display panel, an electrophoretic display panel, and the like, are being developed.

The organic light emitting display panel may include anodes, cathodes, and emission patterns. The emission patterns may be separated for respective emissive regions, and the cathodes may provide a common voltage for the respective emissive regions.

### SUMMARY

Embodiments of the present disclosure provide a display device for preventing a defect due to a dent in a spacer and improving the sensitivity of a touch sensor and a method for manufacturing the display device.

According to an embodiment, a display device includes a pixel defining layer including a light emitting opening defined therein, a barrier wall layer on the pixel defining layer, the barrier wall layer comprising barrier walls spaced apart from each other and defining a barrier wall opening of the barrier wall layer which is between the barrier walls, the barrier wall opening overlapping the light emitting opening of the pixel defining layer, a light emitting element overlapping the light emitting opening of the pixel defining layer, and a spacer which is on a barrier wall among the barrier walls and spaced apart from the light emitting opening and the barrier wall opening. The barrier wall which has the spacer thereon defines a blocking opening of the barrier wall which surrounds the spacer.

The display device may further include a base layer including a display region including an emissive region and a non-emissive region and a non-display region adjacent to the display region, the spacer may be disposed on a barrier wall among the barrier walls spaced apart from the light emitting opening and the barrier wall opening in a plan view. The barrier wall layer further may comprise among the barrier walls a first barrier wall layer and a second barrier wall layer which is on the first barrier wall layer, and at the blocking opening, the second barrier wall layer protruding further than the first barrier wall layer and defining a first blocking tip portion at the second barrier wall layer.

The blocking opening may include a first opening portion defined in the first barrier wall layer and a second opening portion defined in the second barrier wall layer, and a width of the first opening portion may be greater than a width of the second opening portion.

The width of the second opening portion may be equal to or greater than about 0.1 micrometer (µm).

The width of the second opening portion may be equal to or less than about 1 µm.

An inner surface of the barrier wall layer may define the barrier wall opening, the light emitting element may include a first electrode, an emission pattern on the first electrode, and a second electrode on the emission pattern, and the second electrode may make contact with an inner surface of the first barrier wall layer which defines the barrier wall opening.

The display device may further include an encapsulation layer which on the light emitting element and which covers the light emitting element. The encapsulation layer may include a lower inorganic encapsulation layer which on the light emitting element and which covers the light emitting element and the barrier walls, an organic encapsulation film which on the lower inorganic encapsulation layer, and an upper inorganic encapsulation layer on the organic encapsulation film.

An inner surface of the barrier wall layer may define the blocking opening, the lower inorganic encapsulation layer may extend along the inner surface of the barrier wall layer which defines the blocking opening, and the organic encapsulation film may extend along the lower inorganic encapsulation layer and into the blocking opening.

The blocking opening may be open to outside the barrier wall layer at an inlet, the lower inorganic encapsulation layer may extend across the inlet and cover and seal the blocking opening, and the blocking opening which is sealed by the lower inorganic encapsulation layer may be filled with air.

The barrier wall layer may further have among the barrier walls a first barrier wall which has the spacer thereon and defines the blocking opening and a second barrier wall defining an opening of the second barrier wall which is spaced apart from both the light emitting opening and the blocking opening. The lower inorganic encapsulation layer may extend across the inlet and cover and seal the opening. The opening which is sealed by the lower inorganic encapsulation layer may be filled with air.

The organic encapsulation film of the encapsulation layer may have a thickness of equal to or greater than about 0.1 µm equal to or less than about 20 micrometers (µm).

The organic encapsulation film of the encapsulation layer may have a permittivity of equal to or greater than about 2.0 and equal to or less than about 3.2.

The display device may further include an input sensor directly on the encapsulation layer. The input sensor may include a sensor base layer directly on the encapsulation layer, a first sensor conductive layer on the sensor base layer, a sensor insulating layer which is on the first sensor conductive layer and which covers the first sensor conductive layer, and a second sensor conductive layer on the sensor insulating layer.

The barrier wall layer may further include a first barrier wall layer, a second barrier wall layer, a third barrier wall layer and a fourth barrier wall layer in order from the pixel defining layer, and the first barrier wall layer, the second barrier wall layer, the third barrier wall layer and the fourth barrier wall layer may define the blocking opening which surrounds the spacer.

At the blocking opening, the second barrier wall layer protrudes further than the first barrier wall layer and defines a first blocking tip portion at the second barrier wall layer. The fourth barrier wall layer may protrude further than the third barrier wall layer and defines a second blocking tip portion at the fourth barrier wall layer.

According to an embodiment, a display device includes a base layer, a pixel defining layer that is disposed on the base layer and that has a light emitting opening defined therein, a barrier wall that has a barrier wall opening defined therein overlapping the light emitting opening and includes a first barrier wall layer disposed on the pixel defining layer and a second barrier wall layer disposed on the first barrier wall layer, a light emitting element that overlaps the light emitting opening and includes a first electrode, an emission pattern disposed on the first electrode, and a second electrode disposed on the emission pattern, and a spacer disposed on the second barrier wall layer non-overlapping the light emitting opening. The barrier wall has a first blocking opening defined therein surrounding the spacer in a plan view.

The second barrier wall layer may include a first blocking tip portion that protrudes toward the first blocking opening with respect to the first barrier wall layer.

The first blocking opening may include a first opening portion defined in the first barrier wall layer and a second opening portion defined in the second barrier wall layer, and a width of the first opening portion may be greater than a width of the second opening portion.

The width of the second opening portion may be equal to or greater than about 0.1 µm.

The width of the second opening portion may be equal to or less than about 1 µm.

The second electrode may make contact with an inner surface of the first barrier wall layer that defines the barrier wall opening.

The display device may further include a thin film encapsulation layer that is disposed on the light emitting element and that covers the light emitting element. The thin film encapsulation layer may include a lower inorganic encapsulation layer that is disposed on the light emitting element and that covers the light emitting element and the barrier wall, an organic encapsulation film that is disposed on the lower inorganic encapsulation layer and that provides a flat upper surface, and an upper inorganic encapsulation layer disposed on the organic encapsulation film.

The lower inorganic encapsulation layer may extend along an inner surface of the barrier wall that defines the first blocking opening, and the organic encapsulation film may be disposed in the first blocking opening.

The lower inorganic encapsulation layer may cover and seal the first blocking opening, and the first blocking opening may be filled with air.

The barrier wall may have an opening defined therein non- overlapping the light emitting opening and the first blocking opening. The lower inorganic encapsulation layer may cover and seal the opening. The opening may be filled with air.

The organic encapsulation film may have a thickness of equal to or greater than about 0.1 µm equal to or less than about 20 µm.

The organic encapsulation film may have a permittivity of equal to or greater than about 2.0 equalt to or less than about 3.2.

The display device may further include an input sensor directly disposed on the thin film encapsulation layer. The input sensor may include a sensor base layer directly disposed on the thin film encapsulation layer, a first sensor conductive layer disposed on the sensor base layer, a sensor insulating layer that is disposed on the first sensor conductive layer and that covers the first sensor conductive layer, and a second sensor conductive layer disposed on the sensor insulating layer.

The barrier wall may further include a third barrier wall layer disposed on the second barrier wall layer and a fourth barrier wall layer disposed on the third barrier wall layer, and the third barrier wall layer and the fourth barrier wall layer may have a second blocking opening defined therein surrounding the spacer in a plan view and extending from the first blocking opening.

The fourth barrier wall layer may include a second blocking tip portion that protruding toward the second blocking opening with respect to the third barrier wall layer.

According to an embodiment, a display device includes a base layer including a display region including an emissive region and a non-emissive region and a non-display region adjacent to the display region, a barrier wall which has a barrier wall opening defined therein corresponding to the emissive region, a light emitting element which overlaps the emissive region, and a spacer which is on a barrier wall among the barrier walls and overlaps the non-emissive region of the display region. The barrier wall which has the spacer thereon defines a blocking opening of the barrier wall which is between the spacer and the light emitting element.

The barrier wall layer may further include a first barrier wall layer and a second barrier wall layer which is on the first barrier wall layer, and at the blocking opening, the second barrier wall layer protruding further than the first barrier wall layer and defining a blocking tip portion at the second barrier wall layer.

The blocking opening may include a first opening portion defined in the first barrier wall layer and a second opening portion defined in the second barrier wall layer, and a width of the first opening portion may be greater than a width of the second opening portion.

The width of the second opening portion may be equal to or less than about 1 µm.

An inner surface of the barrier wall layer may define the barrier wall opening, the light emitting element may include a first electrode, an emission pattern on the first electrode, and a second electrode on the emission pattern, and the second electrode may contact the inner surface of the barrier wall layer at the barrier wall opening.

### BRIEF DESCRIPTION OF THE FIGURES

The above and other objects and features of the present disclosure will become apparent by describing in detail embodiments thereof with reference to the accompanying drawings.
FIG. 1 is a perspective view of a display device according to an embodiment of the present disclosure.
FIG. 2 is an exploded perspective view of the display device according to an embodiment of the present disclosure.
FIG. 3 is a cross-sectional view of a display module according to an embodiment of the present disclosure.
FIG. 4 is a plan view of a display panel according to an embodiment of the present disclosure.
FIG. 5 is an equivalent circuit diagram of a pixel according to an embodiment of the present disclosure.
FIG. 6 is a plan view of an input sensor according to an embodiment of the present disclosure.
FIG. 7 is an enlarged plan view of a portion of a display region of the display panel according to an embodiment of the present disclosure.
FIG. 8 is an enlarged cross-sectional view of the display panel taken along line I-I' of FIG. 4 according to an embodiment of the present disclosure.
FIG. 9 is an enlarged cross-sectional view taken along line II-II' of FIG. 7 according to an embodiment of the present disclosure.
FIG. 10 is an enlarged sectional view illustrating region AA' of FIG. 9 according to an embodiment of the present disclosure.
FIG. 11 is a sectional view taken along line II-II' of FIG. 7 according to an embodiment of the present disclosure.
FIG. 12 is an enlarged sectional view illustrating region AA" of FIG. 11 according to an embodiment of the present disclosure.
FIG. 13 is an enlarged plan view of a portion of the display region of the display panel according to an embodiment of the present disclosure.
FIG. 14 is a sectional view taken along line III-III' of FIG. 13 according to an embodiment of the present disclosure.
FIG. 15 is an enlarged sectional view illustrating region BB' of FIG. 14 according to an embodiment of the present disclosure.
FIG. 16 is a sectional view taken along line II-II' of FIG. 7 according to an embodiment of the present disclosure.
FIG. 17 is a sectional view taken along line II-II' of FIG. 7 according to an embodiment of the present disclosure.
FIGS. 18A to 18H are cross-sectional views illustrating processes in a method of providing a display panel according to an embodiment of the present disclosure.

### DETAILED DESCRIPTION

In this specification, when it is mentioned that a component (or, an area, a layer, a part, etc.) is referred to as being related to another element such as being "on", "connected to" or "coupled to" another component, this means that the component may be directly on, connected to, or coupled to the other component or a third component may be present therebetween. In contrast, when it is mentioned that a component (or, an area, a layer, a part, etc.) is referred to as being related to another element such as being "directly on", "directly connected to" or "directly coupled to" another component, this means that no third component is present therebetween.

Like reference numerals refer to like components. Within the As used in the Figures and the text of the disclosure, a reference number indicating a singular form of an element may also be used to reference a plurality of the singular element. Additionally, in the drawings, the thicknesses, proportions, and dimensions of components are exaggerated for effective description.

The terminology used herein is for the purpose of describing particular embodiments only and is not intended to be limiting. As used herein, "a", "an," "the," and "at least one" do not denote a limitation of quantity, and are intended to include both the singular and plural, unless the context clearly indicates otherwise. Thus, reference to "an" element in a claim followed by reference to "the" element is inclusive of one element and a plurality of the elements. For example, "an element" has the same meaning as "at least one element," unless the context clearly indicates otherwise. "At least one" is not to be construed as limiting "a" or "an." "Or" means "and/or." As used herein, the term "and/or" includes all of one or more combinations defined by related components.

Terms such as first, second, and the like may be used to describe various components, but the components should not be limited by the terms. The terms may be used only for distinguishing one component from other components. For example, without departing the scope of the present disclosure, a first component may be referred to as a second component, and similarly, the second component may also be referred to as the first component. The terms of a singular form may include plural forms unless otherwise specified.

In addition, terms such as "below", "under", "above", and "over" are used to describe a relationship of components illustrated in the drawings. The terms are relative concepts and are described based on directions illustrated in the drawing.

It should be understood that terms such as "comprise", "include", and "have", when used herein, specify the presence of stated features, numbers, steps, operations, components, parts, or combinations thereof, but do not preclude the presence or addition of one or more other features, numbers, steps, operations, components, parts, or combinations thereof.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" can mean within one or more standard deviations, or within ± 30%, 20%, 10% or 5% of the stated value.

Unless otherwise defined, all terms used herein, including technical or scientific terms, have the same meanings as those generally understood by those skilled in the art to which the present disclosure pertains. Such terms as those defined in a generally used dictionary are to be interpreted as having meanings equal to the contextual meanings in the relevant field of art, and are not to be interpreted as having ideal or excessively formal meanings unless clearly defined as having such in the present application.

Hereinafter, embodiments of the present disclosure will be described with reference to the accompanying drawings.

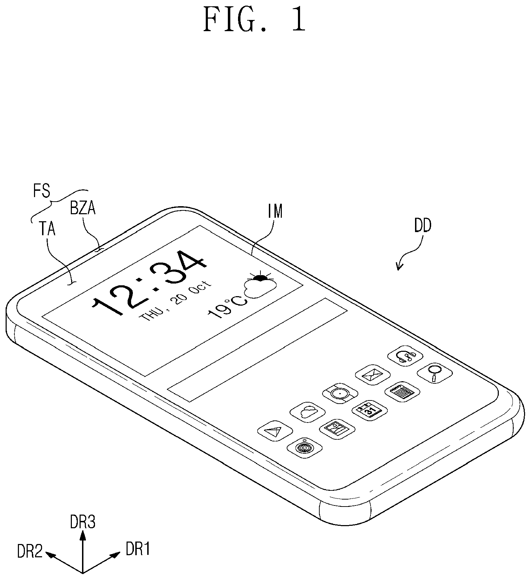

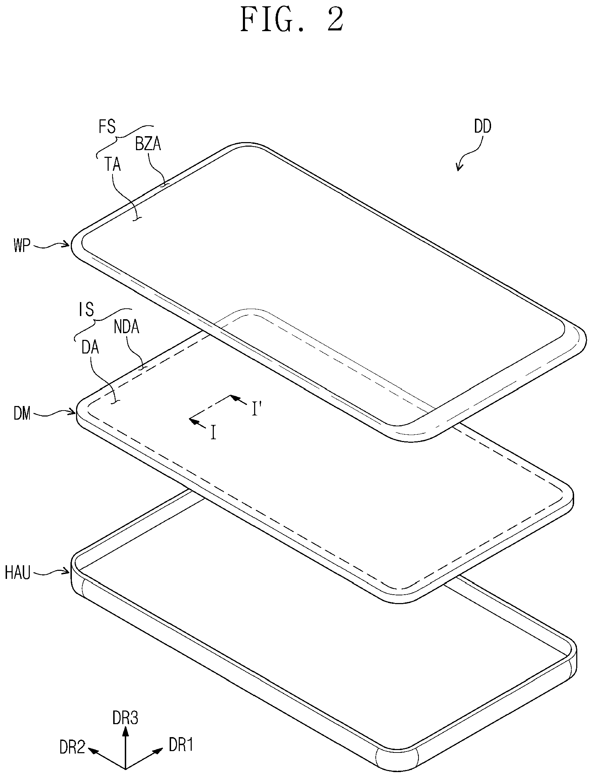

FIG. 1 is a perspective view of a display device DD according to an embodiment of the present disclosure. FIG. 2 is an exploded perspective view of the display device DD according to an embodiment of the present disclosure.

In an embodiment, the display device DD may be a large electronic device such as a television, a monitor, or a billboard. Alternatively, the display device DD may be a small and medium-sized electronic device such as a personal computer, a notebook computer, a personal digital terminal, a car navigation unit, a game machine, a smart phone, a tablet computer, or a camera. However, this is illustrative, and the display device DD may be employed as other display devices without departing from the scope of the present disclosure. In FIGS. 1 and 2, the display device DD is illustrated as a smart phone.

Referring to FIGS. 1 and 2, the display device DD may display an image IM in a third direction DR3 at a display surface FS parallel to a plane defined by a first direction DR1 and a second direction DR2 crossing each other. The third direction DR3 may be a normal direction of the plane defined by the first direction DR1 and the second direction DR2 crossing each other. The image IM may include a still image as well as a dynamic image. In FIG. 1, a clock window and icons are illustrated as examples of the image IM. The display surface FS on which the image IM is displayed may correspond to the front surface of the display device DD.

In this embodiment, front surfaces (or, upper surfaces) and rear surfaces (or, lower surfaces) of members are defined based on the direction in which the image IM is displayed. The front surfaces and the rear surfaces may face away from each other in the third direction DR3, and the normal directions of the front surfaces and the rear surfaces may be parallel to the third direction DR3. The directions indicated by the first to third directions DR1, DR2, and DR3 may be relative concepts and may be changed to other directions. As used herein, the expression "from above the plane" may mean that it is viewed in (or along) the third direction DR3.

The display device DD may include a window WP, a display module DM, and a housing HAU. The window WP and the housing HAU may be coupled with each other to form the exterior of the display device DD.

The window WP may include an optically clear insulating material. For example, the window WP may include glass or plastic. The front surface of the window WP may define the display surface FS of the display device DD. The display surface FS may include a transmission region TA and a bezel region BZA. The transmission region TA may be an optically clear region for light transmission therethrough. For example, the transmission region TA may be a region having a visible light transmittance of about 90% or more.

The bezel region BZA may be a region having a lower light transmittance than that of the transmission region TA. The bezel region BZA may define the shape of the transmission region TA along a plane, that is, a planar shape of the transmission region TA. The bezel region BZA may be adjacent to the transmission region TA. In an embodiment, the bezel region BZA may surround the transmission region TA. However, this is illustrative, and the bezel region BZA of the window WP may be omitted. The window WP may further include at least one of an anti-fingerprint layer, a hard coating layer, and an anti-reflection layer on or defining the optically clear insulating material and is not limited to any one embodiment.

The display module DM may be disposed under the window WP. The display module DM may be a component which substantially generates the image IM. The image IM generated by the display module DM is displayed on a display surface IS of the display module DM and visually recognized from the outside (e.g., outside of the display device DD), such as by a user, through the transmission region TA.

The display module DM may include a display region DA and a non-display region NDA. The display region DA may be a region activated depending on an electrical signal. The non-display region NDA may be adjacent to the display region DA. The non-display region NDA may surround the display region DA. The non-display region NDA may be a region covered by the bezel region BZA and may not be visible from the outside.

The housing HAU may be coupled with the window WP. The housing HAU may be coupled with the window WP to provide an inner space of the display device DD. The display module DM may be accommodated in the inner space.

The housing HAU may include a material having a relatively high rigidity. For example, the housing HAU may include glass, plastic, or metal, or may include a plurality of frames and/or plates formed of or including a combination of the aforementioned materials. The housing HAU may stably protect components of the display device DD accommodated in the inner space from external impact.

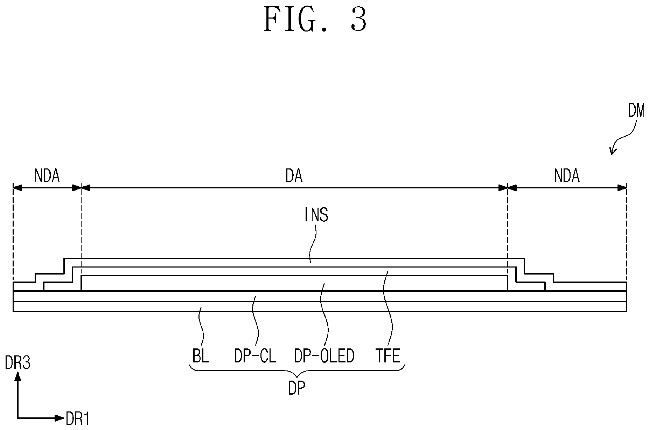

FIG. 3 is a sectional view of the display module DM according to an embodiment of the present disclosure.

Referring to FIG. 3, the display module DM may include a display panel DP and an input sensor INS as an input sensing layer. Although not separately illustrated, the display device DD (refer to FIG. 1) according to an embodiment of the present disclosure may further include a protective member disposed on the lower surface of the display panel DP and/or an anti-reflection member and/or a window member disposed on the upper surface of the input sensor INS.

The display panel DP may be an emissive display panel. However, this is illustrative, and the present disclosure is not particularly limited thereto. For example, the display panel DP may be an organic light emitting display panel or an inorganic light emitting display panel. An emissive layer of the organic light emitting display panel may include an organic luminescent material. An emissive layer in the inorganic light emitting display panel may include quantum dots, quantum rods, or micro light emitting diodes (LEDs). Hereinafter, the display panel DP will be described as an organic light emitting display panel.

The display panel DP may include a base layer BL, and a circuit element layer DP-CL, a display element layer DP-OLED, and a thin film encapsulation layer TFE as an encapsulation layer which are disposed on the base layer BL. The input sensor INS may be directly disposed on the thin film encapsulation layer TFE. As used herein, the expression "component A is directly disposed on component B" means that an adhesive layer or other intervening element is not disposed between component A and component B.

The base layer BL may include at least one plastic film. The base layer BL may be a flexible substrate and may include a plastic substrate, a glass substrate, a metal substrate, or an organic/inorganic composite substrate. The display region DA and the non-display region NDA described with reference to FIG. 2 may be identically defined in the base layer BL.

The circuit element layer DP-CL may include at least one insulating layer and a circuit element. The insulating layer includes at least one inorganic layer and at least one organic layer. The circuit element includes signal lines and a pixel drive circuit.

The display element layer DP-OLED may include a barrier wall and light emitting elements. Each of the light emitting elements may include an anode, an intermediate layer, and a cathode. The display element layer DP-OLED is electrically connected to the circuit element layer DP-CL.

The thin film encapsulation layer TFE may include a plurality of thin films. Some of the thin films may be disposed to improve optical efficiency, and the other thin films may be disposed to protect organic light emitting diodes.

The input sensor INS obtains coordinate information of an external input. The input sensor INS may have a multi-layer structure. The input sensor INS may include a single conductive layer or multiple conductive layers. Furthermore, the input sensor INS may include a single insulating layer or multiple insulating layers. The input sensor INS may sense the external input in a capacitive type. However, this is illustrative, and the present disclosure is not limited thereto. For example, in an embodiment, the input sensor INS may sense the external input using an electromagnetic induction method or a pressure sensing method. In an embodiment of the present disclosure, the input sensor INS may be omitted.

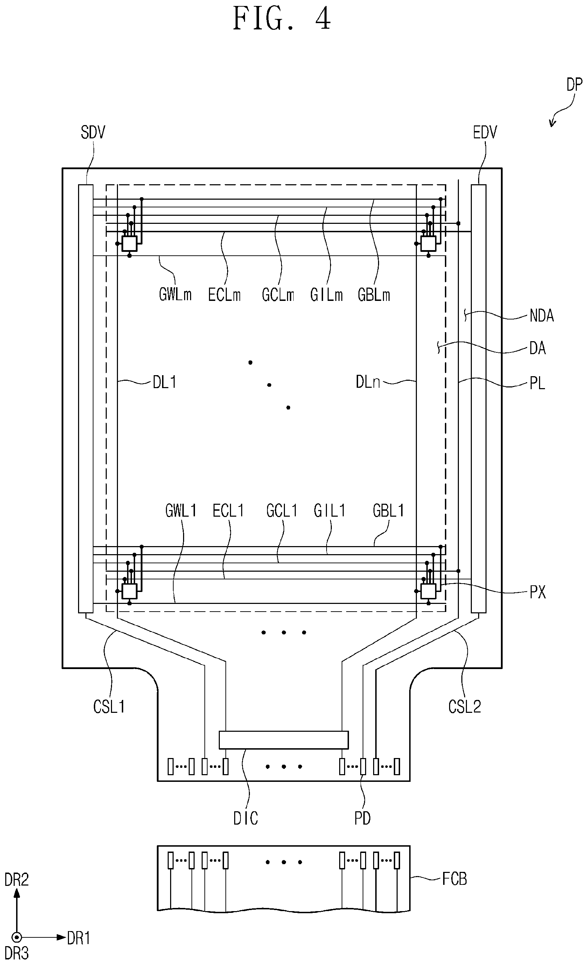

FIG. 4 is a plan view of the display panel DP according to an embodiment of the present disclosure.

Referring to FIG. 4, a display region DA and a non-display region NDA which is extended along a boundary of the display region DA may be defined in the display panel DP. The display region DA and the non-display region NDA may be distinguished from each other depending on whether pixels PX are disposed therein. The pixels PX may be disposed in the display region DA and may not be disposed in the non-display region NDA.

The display panel DP may include the pixels PX, initialization scan lines GIL1 to GILm, compensation scan lines GCL1 to GCLm, write scan lines GWL1 to GWLm, black scan lines GBL1 to GBLm, emission control lines ECL1 to ECLm, data lines DL1 to DLn, first and second control lines CSL1 and CSL2 and a drive voltage line PL as various signal lines transmitting electrical signals, a scan driver SDV, a data driver (not shown), an emission driver EDV, a driver such as a driver integrated circuit (driver IC) DIC, and a pad PD provided in plural including pads PD. Here, "m" and "n" are natural numbers of 2 or larger. The data driver may be a circuit configured in the driver IC DIC.

The pixels PX may be variously connected to (e.g., electrically connected to) the initialization scan lines GIL1 to GILm, the compensation scan lines GCL1 to GCLm, the write scan lines GWL1 to GWLm, the black scan lines GBL1 to GBLm, the emission control lines ECL1 to ECLm, and the data lines DL1 to DLn.

The initialization scan lines GIL1 to GILm, the compensation scan lines GCL1 to GCLm, the write scan lines GWL1 to GWLm, and the black scan lines GBL1 to GBLm may extend in the first direction DR1 and may be electrically connected to the scan driver SDV. The data lines DL1 to DLn may extend in the second direction DR2 and may be electrically connected to the driver IC DIC. The emission control lines ECL1 to ECLm may extend in the first direction DR1 and may be electrically connected to the emission driver EDV. An extension direction in which a component or element extends may be defined by a major dimension thereof, without being limited thereto.

The drive voltage line PL may include a portion extending in the first direction DR1 and a portion extending in the second portion DR2. The portion extending in the first direction DR1 and the portion extending in the second portion DR2 may be disposed on different layers. The drive voltage line PL may provide a drive voltage to the pixels PX.

The first control line CSL1 may be connected to the scan driver SDV. The second control line CSL2 may be connected to the emission driver EDV.

The driver IC DIC, the drive voltage line PL, the first control line CSL1, and the second control line CSL2 may be variously electrically connected to the pads PD. A flexible circuit film FCB may be electrically connected to the display panel DP, at the pads PD, through an anisotropic conductive adhesive layer between the display panel DP and the flexible circuit film FCB. The pads PD may be terminal pads for connecting the flexible circuit film FCB to the display panel DP. The pads PD may be electrically connected to corresponding pixels PX through the drive voltage line PL, the first control line CSL1, and the second control line CSL2.

In addition, the pads PD may further include input pads. The input pads may be pads for connecting the flexible circuit film FCB to the input sensor INS (refer to FIG. 3). However, without being limited thereto, the input pads may be disposed in the input sensor INS and may be connected with the pads PD through a separate circuit board. Alternatively, the input sensor INS may be omitted and may not further include the input pads.

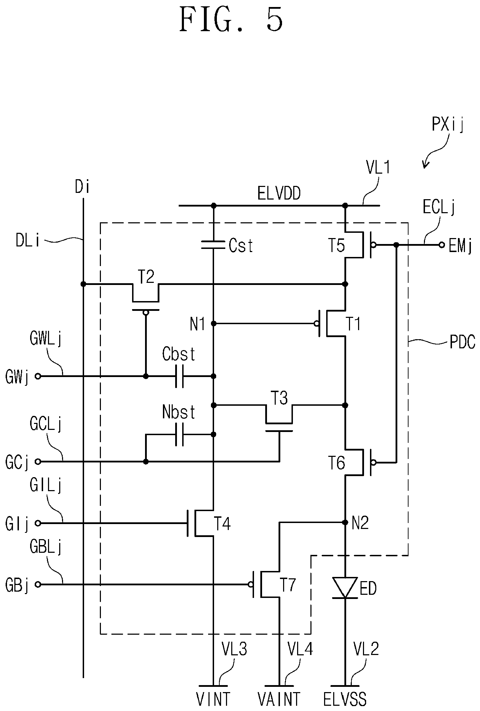

FIG. 5 is an equivalent circuit diagram of a pixel PX according to an embodiment of the present disclosure.

In FIG. 5, an equivalent circuit diagram of one pixel PXij among the plurality of pixels PX (refer to FIG. 4) is illustrated. Since the plurality of pixels PX have the same circuit structure, description of a circuit structure for the pixel PXij may be applied to the remaining pixels PX, and detailed description of the remaining pixels PX will be omitted.

Referring to FIGS. 4 and 5, the pixel PXij is connected to the i-th data line DLi among the data lines DL1 to DLn, the j-th initialization scan line GILj among the initialization scan lines GIL1 to GILm, the j-th compensation scan line GCLj among the compensation scan lines GCL1 to GCLm, the j-th write scan line GWLj among the write scan lines GWL1 to GWLm, the j-th black scan line GBLj among the black scan lines GBL1 to GBLm, the j-th emission control line ECLj among the emission control lines ECL1 to ECLm, first and second drive voltage lines VL1 and VL2, and first and second initialization voltage lines VL3 and VL4. Here, "i" is an integer of 1 to 'n,' and "j" is an integer of 1 to 'm.'

The pixel PXij includes a light emitting element ED and a pixel circuit PDC. The light emitting element ED may be a light emitting diode. In an embodiment of the present disclosure, the light emitting element ED may be an organic light emitting diode including an organic light emitting layer, but is not particularly limited thereto. The pixel circuit PDC may control the amount of current (e.g., electrical current) flowing through the light emitting element ED in response to a data signal Di. The light emitting element ED may emit light having a certain luminance in response to the amount of current provided from the pixel circuit PDC.

The pixel circuit PDC may include first to seventh transistors T1, T2, T3, T4, T5, T6, and T7 and first to third capacitors Cst, Cbst, and Nbst. A configuration of the pixel circuit PDC according to the present disclosure is not limited to the embodiment illustrated in FIG. 5. The pixel circuit PDC illustrated in FIG. 5 is merely illustrative, and various changes and modifications may be made to the configuration of the pixel circuit PDC.

At least one of the first to seventh transistors T1, T2, T3, T4, T5, T6, and T7 may be a transistor having a low-temperature polycrystalline silicon (LTPS) semiconductor layer. At least one of the first to seventh transistors T1, T2, T3, T4, T5, T6, and T7 may be a transistor having an oxide semiconductor layer. For example, the third and fourth transistors T3 and T4 may be oxide semiconductor transistors, and the first, second, fifth, sixth, and seventh transistors T1, T2, T5, T6, and T7 may be LTPS transistors.

Specifically, the first transistor T1 directly affecting the brightness of the light emitting element ED may include a semiconductor layer formed of (or including) polycrystalline silicon having high reliability, and thus, the display device DD having a high resolution may be implemented. An oxide semiconductor has high carrier mobility and low leakage current, and thus, a voltage drop is minimal even though operating time is long. That is, the color of an image IM is not greatly changed depending on a voltage drop even during a low-frequency operation, and thus, the low-frequency operation is possible. Since the oxide semiconductor has an advantage of low leakage current as described above, at least one of the third transistor T3 which is connected with a gate electrode of the first transistor T1, and the fourth transistor T4, may be employed as an oxide semiconductor to reduce power consumption while preventing leakage current which is likely to flow to the gate electrode.

Some of the first to seventh transistors T1, T2, T3, T4, T5, T6, and T7 may be P-type transistors, and the others may be N-type transistors. For example, the first, second, fifth, sixth, and seventh transistors T1, T2, T5, T6, and T7 may be P-type transistors, and the third and fourth transistors T3 and T4 may be N-type transistors.

The configuration of the pixel circuit PDC according to the present disclosure is not limited to the embodiment illustrated in FIG. 5. The pixel circuit PDC illustrated in FIG. 5 is merely illustrative, and various changes and modifications may be made to the configuration of the pixel circuit PDC. For example, the first to seventh transistors T1, T2, T3, T4, T5, T6, and T7 may all be P-type transistors or N-type transistors. Alternatively, the first, second, fifth, and sixth transistors T1, T2, T5, and T6 may be P-type transistors, and the third, fourth, and seventh transistors T3, T4, and T7 may be N-type transistors.

The j-th initialization scan line GILj, the j-th compensation scan line GCLj, the j-th write scan line GWLj, the j-th black scan line GBLj, and the j-th emission control line ECLj may transfer the j-th initialization scan signal Glj, the j-th compensation scan signal GCj, the j-th write scan signal GWj, the j-th black scan signal GBj, and the j-th emission control signal EMj to the pixel PXij, respectively. The i-th data line DLi transfers the i-th data signal Di to the pixel PXij. The i-th data signal Di may have a voltage level corresponding to an image signal which is input to the display device DD (refer to FIG. 1).

The first and second drive voltage lines VL1 and VL2 may transfer a first drive voltage ELVDD and a second drive voltage ELVSS to the pixel PXij, respectively. In addition, the first and second initialization voltage lines VL3 and VL4 may transfer a first initialization voltage VINT and a second initialization voltage VAINT to the pixel PXij, respectively.

The first transistor T1 is connected between the first drive voltage line VL1, which receives the first drive voltage ELVDD, and the light emitting element ED. The first transistor T1 includes a first electrode connected with the first drive voltage line VL1 via the fifth transistor T5, a second electrode connected with a pixel electrode (or, referred to as an anode) of the light emitting element ED via the sixth transistor T6, and a third electrode (e.g., a gate electrode) connected with one end of the first capacitor Cst (e.g., a first node N1). The first transistor T1 may receive the i-th data signal Di which the i-th data line DLi transfers depending on a switching operation of the second transistor T2 and may supply a drive current to the light emitting element ED.

The second transistor T2 is connected between the i-th data line DLi and the first electrode of the first transistor T1. The second transistor T2 includes a first electrode connected with the i-th data line DLi, a second electrode connected with the first electrode of the first transistor T1, and a third electrode (e.g., a gate electrode) connected with the j-th write scan line GWLj. The second transistor T2 may be turned on in response to the j-th write scan signal GWj transferred through the j-th write scan line GWLj and may transfer, to the first electrode of the first transistor T1, the i-th data signal Di transferred from the i-th data line DLi. One end of the second capacitor Cbst may be connected to the third electrode of the second transistor T2, and an opposite end of the second capacitor Cbst may be connected to the first node N1.

The third transistor T3 is connected between the second electrode of the first transistor T1 and the first node N1. The third transistor T3 includes a first electrode connected with the third electrode of the first transistor T1, a second electrode connected with the second electrode of the first transistor T1, and a third electrode (e.g., a gate electrode) connected with the j-th compensation scan line GCLj. The third transistor T3 may be turned on in response to the j-th compensation scan signal GCj transferred through the j-th compensation scan line GCLj and may diode-connect the first transistor T1 by connecting the third electrode of the first transistor T1 and the second electrode of the first transistor T1. One end of the third capacitor Nbst may be connected to the third electrode of the third transistor T3, and an opposite end of the third capacitor Nbst may be connected to the first node N1.

The fourth transistor T4 is connected between the first initialization voltage line VL3 through which the first initialization voltage VINT is applied, and the first node N1. The fourth transistor T4 includes a first electrode connected with the first initialization voltage line VL3 through which the first initialization voltage VINT is transferred, a second electrode connected with the first node N1, and a third electrode (e.g., a gate electrode) connected with the j-th initialization scan line GILj. The fourth transistor T4 is turned on in response to the j-th initialization scan signal Glj transferred through the j-th initialization scan line GILj. The turned-on fourth transistor T4 initializes the potential of the third electrode of the first transistor T1 (that is, the potential of the first node N1) by transferring the first initialization voltage VINT to the first node N1.

The fifth transistor T5 includes a first electrode connected with the first drive voltage line VL1, a second electrode connected with the first electrode of the first transistor T1, and a third electrode (e.g., a gate electrode) connected to the j-th emission control line ECLj. The sixth transistor T6 includes a first electrode connected with the second electrode of the first transistor T1, a second electrode connected to the pixel electrode of the light emitting element ED, and a third electrode (e.g., a gate electrode) connected to the j-th emission control line ECLj.

The fifth and sixth transistors T5 and T6 are simultaneously turned on in response to the j-th emission control signal EMj transferred through the j-th emission control line ECLj. The first drive voltage ELVDD applied through the turned-on fifth transistor T5 may be compensated for through the diode-connected first transistor T1 and thereafter may be transferred to the light emitting element ED through the sixth transistor T6.

The seventh transistor T7 includes a first electrode connected to the second initialization voltage line VL4 through which the second initialization voltage VAINT is transferred, a second electrode connected with the second electrode of the sixth transistor T6, and a third electrode (e.g., a gate electrode) connected with the j-th black scan line GBLj. The second initialization voltage VAINT may have a voltage level lower than or equal to the voltage level of the first initialization voltage VINT.

The one end of the first capacitor Cst is connected with the third electrode of the first transistor T1, and an opposite end of the first capacitor Cst is connected with the first drive voltage line VL1. A cathode of the light emitting element ED may be connected with the second drive voltage line VL2 which transfers the second drive voltage ELVSS. The second drive voltage ELVSS may have a lower voltage level than the first drive voltage ELVDD.

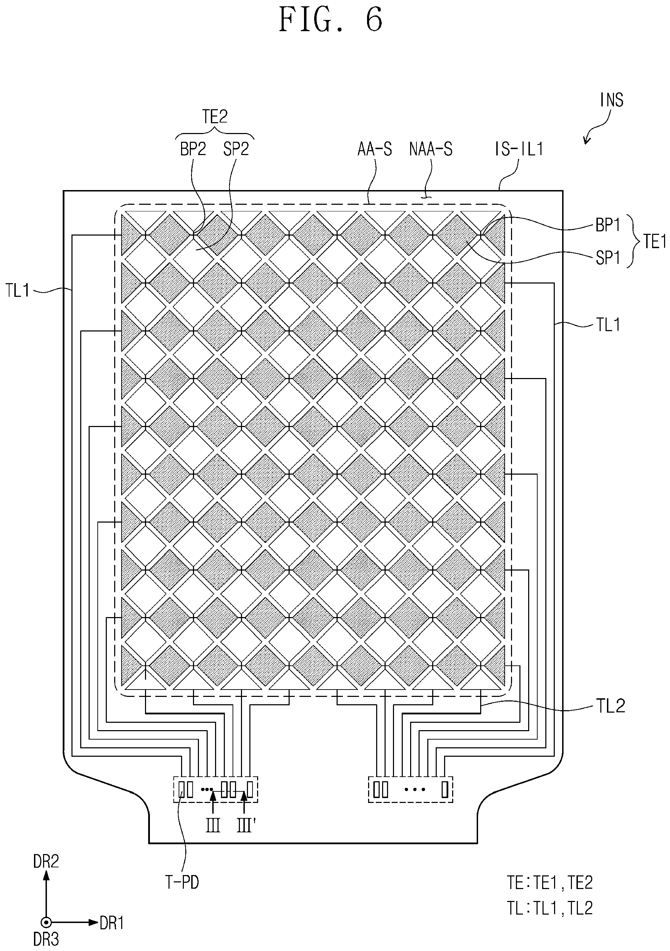

FIG. 6 is a plan view of the input sensor INS according to an embodiment of the present disclosure.

Referring to FIG. 6, the input sensor INS may include a sensing region AA-S and a non-sensing region NAA-S which is adjacent to the sensing region AA-S. The sensing region AA-S may correspond to the display region DA (refer to FIG. 4) of the display module DM. The sensing region AA-S may be a region or planar area in which sensing electrodes TE of the input sensor INS are disposed and which senses an external input. The non-sensing region NAA-S may correspond to the non-display region NDA (refer to FIG. 4) of the display module DM. The non-sensing region NAA-S may be a region in which elements or signal lines for driving the sensing electrodes TE disposed in the sensing region AA-S are disposed.

The input sensor INS may include the sensing electrodes TE, sensing lines TL, and sensing pads T-PD disposed on a sensor base layer IS-IL1.

The sensing electrodes TE may include first sensing electrodes TE1 and second sensing electrodes TE2 which cross each other on the plane and which are electrically isolated (or insulated) from each other. The input sensor INS may obtain information about an external input through a change in mutual capacitance between the first sensing electrodes TE1 and the second sensing electrodes TE2, such as to determine a location of the external input along a planar direction.

Each of the first sensing electrodes TE1 may extend in the first direction DR1, and the first sensing electrodes TE1 may be arranged spaced apart from each other in the second direction DR2. The first sensing electrodes TE1 may be provided in a plurality of rows arranged spaced apart from each other in the second direction DR2. Although ten first sensing electrodes TE1 arranged spaced apart in the second direction DR2 are illustrated in FIG. 6, the number of first sensing electrodes TE1 included in the input sensor INS is not limited thereto.

Each of the second sensing electrodes TE2 may extend in the second direction DR2, and the second sensing electrodes TE2 may be arranged spaced apart from each other in the first direction DR1. The second sensing electrodes TE2 may be provided in a plurality of columns arranged spaced apart from each other in the first direction DR1. Although eight second sensing electrodes TE2 arranged spaced apart in the first direction DR1 are illustrated in FIG. 6, the number of second sensing electrodes TE2 included in the input sensor INS is not limited thereto.

Each of the first sensing electrodes TE1 may include first sensing patterns SP1 and first connecting patterns BP1. The first sensing patterns SP1 may be arranged spaced apart in the first direction DR1. The first connecting patterns BP1 may connect the first sensing patterns SP1 adjacent to each other in the first direction DR1, to each other. The first connecting patterns BP1 may be disposed on the same layer as the first sensing patterns SP1. The first connecting patterns BP1 may extend from the first sensing patterns SP1 on the plane and may form one body as a first sensing electrode TE1. The first sensing patterns SP1 and the first connecting patterns BP1 may be patterns formed by or provided by patterning a same or single conductive layer through the same process, at the same time, etc. However, embodiments are not limited thereto as long as the first connecting patterns BP1 electrically connect the first sensing patterns SP1 adjacent to each other in the first direction DR1.

Each of the second sensing electrodes TE2 may include second sensing patterns SP2 and second connecting patterns BP2. The second sensing patterns SP2 may be arranged spaced apart in the second direction DR2. The second connecting patterns BP2 may connect the second sensing patterns SP2 adjacent to each other in the second direction DR2, to each other. The second connecting patterns BP2 may be disposed on a layer different from the second sensing patterns SP2 and may be connected with the corresponding second sensing patterns SP2 through contact holes. The second sensing patterns SP2 spaced apart from each other in the second direction DR2 may be electrically connected to each other through the second connecting patterns BP2. The second connecting patterns BP2 which are disposed on a layer different from the second sensing patterns SP2 and which electrically connect the second sensing patterns SP2 may be defined as bridge patterns.

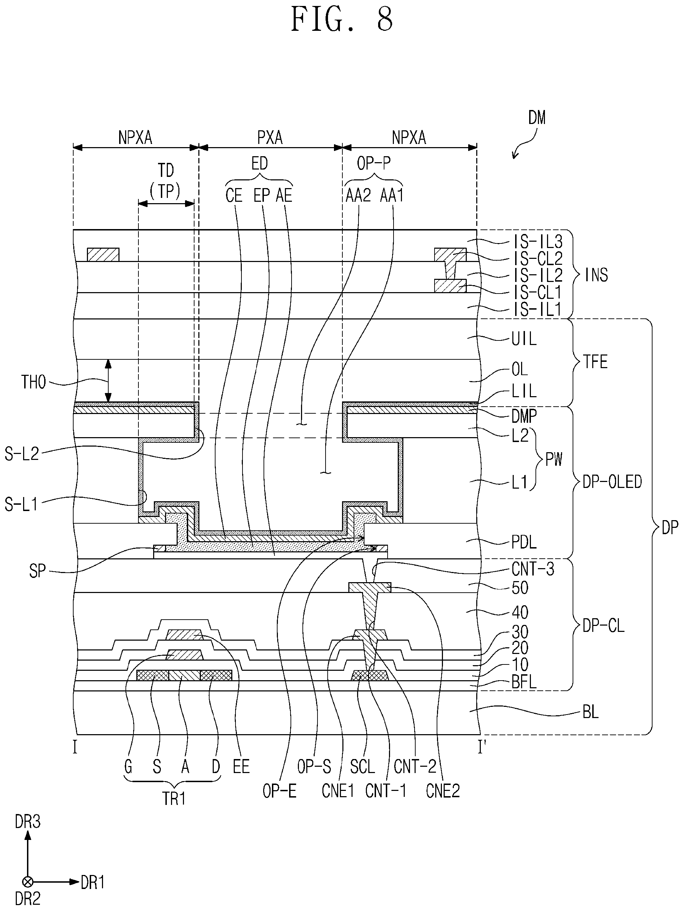

In an embodiment, the first sensing patterns SP1, the first connecting patterns BP1, and the second sensing patterns SP2 may be disposed on the same layer. The second connecting patterns BP2 may be disposed on a layer different from the second sensing patterns SP2. For example, the first sensing patterns SP1, the first connecting patterns BP1, and the second sensing patterns SP2 may be included in a second sensor conductive layer IS-CL2 (refer to FIG. 8), and the second connecting patterns BP2 may be included in a first sensor conductive layer IS-CL1 (refer to FIG. 8). However, without being limited thereto, the first sensing patterns SP1, the first connecting patterns BP1, and the second sensing patterns SP2 may be included in the first sensor conductive layer IS-CL1 (refer to FIG. 8), and the second connecting patterns BP2 may be included in the second sensor conductive layer IS-CL2 (refer to FIG. 8). Alternatively, in an embodiment, the first sensing patterns SP1, the second sensing patterns SP2, and the second connecting patterns BP2 may be disposed on the same layer, and the first connecting patterns BP1 may be disposed on a layer different from the first sensing patterns SP1.

The sensing lines TL may include first sensing lines TL1 and second sensing lines TL2. The first sensing lines TL1 may be connected to the first sensing electrodes TE1, respectively. Each of the first sensing lines TL1 may be connected to a first sensing electrode TE1 in a corresponding row among the first sensing electrodes TE1 provided in a plurality of rows. The second sensing lines TL2 may be connected to the second sensing electrodes TE2, respectively. Each of the second sensing lines TL2 may be connected to a second sensing electrode TE2 in a corresponding column among the second sensing electrodes TE2 provided in a plurality of columns.

The second sensing lines TL2 may be connected to lower ends of the second sensing electrodes TE2 which are adjacent to (or closest to) a pad area including the sensing pads T-PD. The second sensing lines TL2 may extend from the lower ends of the corresponding second sensing electrodes TE2 at the non-sensing region NAA-S and may be connected to the sensing pads T-PD.

As illustrated in FIG. 6, the first sensing lines TL1 may be connected to left or right ends of the first sensing electrodes TE1, respectively. For example, each of first sensing lines TL1 connected to first sensing electrodes TE1 in odd-numbered rows among the first sensing lines TL1 may be connected to a left end of a corresponding first sensing electrode TE1 among the first sensing electrodes TE1 in the odd-numbered rows. Each of first sensing lines TL1 connected to first sensing electrodes TE1 in even-numbered rows among the first sensing lines TL1 may be connected to a right end of a corresponding first sensing electrode TE1 among the first sensing electrodes TE1 in the even-numbered rows. The first sensing lines TL1 may extend in (or along) the second direction DR2 from the respective left or right ends of the corresponding first sensing electrodes TE1 at the non-sensing region NAA-S and may be connected to the sensing pads T-PD.

The sensing pads T-PD may be disposed in the non-sensing region NAA-S. The sensing pads T-PD may be disposed adjacent to the lower end of the sensor base layer IS-IL1 which is furthest from the sensing region AA-S. The sensing pads T-PD may be electrically connected to the sensing lines TL. The sensing pads T-PD may be spaced apart from each other and may be connected to the sensing lines TL, respectively. The sensing pads T-PD may be portions of the input sensing layer at which the input sensing layer is electrically connected to a circuit board which provides drive signals to the input sensing layer. Signals may be applied to the sensing electrodes TE through the sensing pads T-PD and the sensing lines TL, or signals provided from the sensing electrodes TE may be received by the sensing pads T-PD and the sensing lines TL.

In an embodiment, drive signals for driving the first sensing electrodes TE1 and the second sensing electrodes TE2 may be applied to the first sensing electrodes TE1 and the second sensing electrodes TE2 through the second sensing lines TL2. Signals including information sensed by the first sensing electrodes TE1 and the second sensing electrodes TE2 may be output through the first sensing lines TL1. However, embodiments are not necessarily limited thereto.

The sensing pads T-PD may be integrally formed with the sensing lines TL connected thereto, such as form a single body. Unlike those illustrated in FIG. 6, the sensing pads T-PD may not be distinguished from the sensing lines TL, and ends of the sensing lines TL may correspond to sensing pad portions connected with a driver IC on a circuit board.

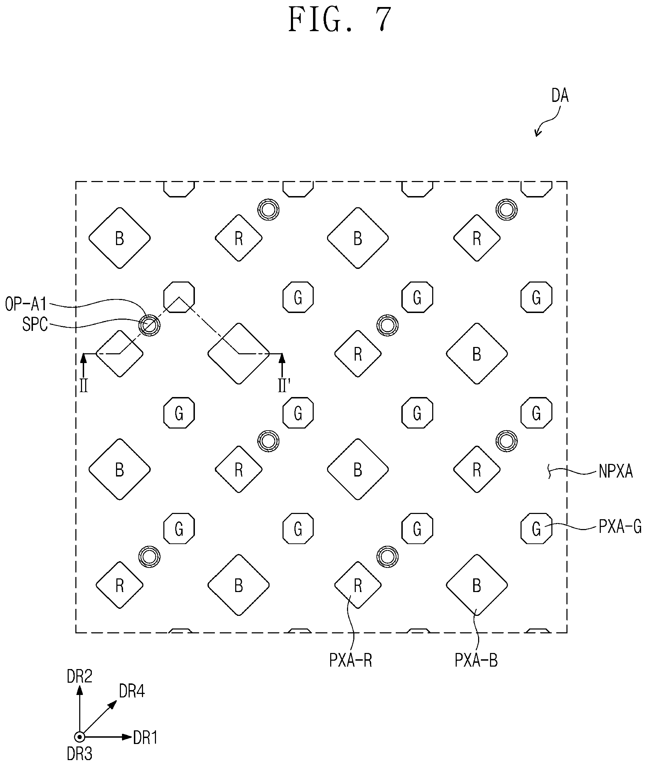

FIG. 7 is an enlarged plan view of a portion of the display region DA of the display panel DP according to an embodiment of the present disclosure. FIG. 7 is a plan view of the display module DM as viewed from above the display surface IS (refer to FIG. 2) of the display module DM (refer to FIG. 2) and illustrates an arrangement of emissive regions PXA-R, PXA-G, and PXA-B as light emission areas.

Referring to FIG. 7, the display region DA may include the first to third emissive regions PXA-R, PXA-G, and PXA-B, and a non-emissive region NPXA adjacent to, such as surrounding each of the first to third emissive regions PXA-R, PXA-G, and PXA-B. The first to third emissive regions PXA-R, PXA-G, and PXA-B may correspond to regions or planar areas through which light provided from light emitting elements ED is emitted. The first to third emissive regions PXA-R, PXA-G, and PXA-B may be distinguished from one another depending on the colors of light emitted toward the outside of the display module DM (refer to FIG. 2).

The first to third emissive regions PXA-R, PXA-G, and PXA-B may provide first to third color light having different colors. For example, the first color light may be red light, the second color light may be green light, and the third color light may be blue light. However, examples of the first color light, the second color light, and the third color light are not necessarily limited thereto.

Each of the first to third emissive regions PXA-R, PXA-G, and PXA-B may be defined as a region corresponding to a planar area of an upper surface of an anode which is is exposed by a light emitting opening which will be described below. The non-emissive region NPXA may set the boundaries respectively between the first to third emissive regions PXA-R, PXA-G, and PXA-B and may prevent color mixing between the first to third emissive regions PXA-R, PXA-G, and PXA-B.

A plurality of first emissive regions PXA-R, a plurality of second emissive regions PXA-G, and a plurality of third emissive regions PXA-B may be provided. The plurality of first emissive regions PXA-R, the plurality of second emissive regions PXA-G, and the plurality of third emissive regions PXA-B may have a predetermined arrangement in the display region DA and may be repeatedly disposed. For example, the first and third emissive regions PXA-R and PXA-B may be alternately arranged in the first direction DR1 to form a "first group" of emissive regions. The second emissive regions PXA-G may be arranged in the first direction DR1 to form a "second group" of emissive regions. The "first group" and the "second group" may be provided in plural numbers, and the "first groups" and the "second groups" may be alternately arranged in the second direction DR2.

One second emissive region PXA-G may be spaced apart from one first emissive region PXA-R or from one third emissive region PXA-B in a fourth direction DR4. The fourth direction DR4 may be defined as a direction between the first and second directions DR1 and DR2, such as a direction inclined with respect to each of the first and second directions DR1 and DR2.

FIG. 7 illustrates an example of an arrangement of the first to third emissive regions PXA-R, PXA-G, and PXA-B, and without being limited thereto, the first to third emissive regions PXA-R, PXA-G, and PXA-B may be arranged in various forms. In an embodiment, the first to third emissive regions PXA-R, PXA-G, and PXA-B may have a PENTILE^{™} arrangement form as illustrated in FIG. 7. Alternatively, the first to third emissive regions PXA-R, PXA-G, and PXA-B may have a stripe arrangement form or a Diamond Pixel^{™} arrangement form.

The first to third emissive regions PXA-R, PXA-G, and PXA-B may have various shapes when viewed from above the plane (e.g., planar shapes). For example, the first to third emissive regions PXA-R, PXA-G, and PXA-B may have a polygonal, circular, or oval planar shape. FIG. 7 illustrates the first and third emissive regions PXA-R and PXA-B having a quadrangular planar shape (or, a rhombic planar shape) when viewed from above the plane and the second emissive regions PXA-G having an octagonal planar shape when viewed from above the plane.

The first to third emissive regions PXA-R, PXA-G, and PXA-B may have the same planar shape when viewed from above the plane, or at least some of the first to third emissive regions PXA-R, PXA-G, and PXA-B may have different planar shapes. FIG. 7 illustrates the first and third emissive regions PXA-R and PXA-B having the same planar shape when viewed from above the plane and the second emissive region PXA-G having a planar shape different from those of the first and third emissive regions PXA-R and PXA-B when viewed from above the plane.

At least some of the first to third emissive regions PXA-R, PXA-G, and PXA-B may have different planar areas or sizes when viewed from above the plane. In an embodiment, the area of the first emissive region PXA-R emitting red light may be greater than the area of the second emissive region PXA-G emitting green light and may be smaller than the area of the third emissive region PXA-B emitting blue light. However, the relative size relationship between the first to third emissive regions PXA-R, PXA-G, and PXA-B depending on emission colors is not limited thereto and may vary depending on the design of the display module DM (refer to FIG. 2). Furthermore, without being limited thereto, the first to third emissive regions PXA-R, PXA-G, and PXA-B may have the same area when viewed from above the plane.

The planar shapes, planar areas, and planar arrangement of the first to third emissive regions PXA-R, PXA-G, and PXA-B of the display module DM (refer to FIG. 2) of the present disclosure may be diversely designed depending on the colors of emitted light or the size and configuration of the display module DM (refer to FIG. 2) and are not limited to the embodiment illustrated in FIG. 7.

A spacer SPC may be disposed in a position not overlapping the emissive regions PXA-R, PXA-G, and PXA-B. The spacer SPC may overlap the non-emissive region NPXA. When viewed from above the plane, a plurality of spacers SPC each having an island shape may be provided around the first to third emissive regions PXA-R, PXA-G, and PXA-B. FIG. 7 illustrates an example in which the spacers SPC are disposed between the first emissive regions PXA-R and the second emissive regions PXA-G. However, the arrangement of the spacers SPC is not limited thereto, and the number and arrangement of spacers SPC disposed in the non-emissive region NPXA may be set in various ways. Although FIG. 7 illustrates an example in which the spacers SPC have a circular shape when viewed from above the plane, the present disclosure is not limited thereto, and the spacers SPC may have various planar shapes.

A first blocking opening OP-A1 may have a shape surrounding the spacer SPC when viewed from above the plane. The blocking opening may have an enclosed shape in a plan view. The first blocking opening OP-A1 may be defined in a barrier wall PW (refer to FIG. 8). Hereinafter, the layer on which the barrier wall PW is disposed is referred to a barrier wall layer. The barrier wall layer includes a plurality of barrier walls. A sidewall of the layer which defines the first blocking opening OP-A1 may be located between an outer edge of the spacer SPC and an outer edge of the first to third emissive regions PXA-R, PXA-G, and PXA-B. The first blocking opening OP-A1 may have an annular shape surrounding the spacer SPC when viewed from above the plane. However, the planar shape of the first blocking opening OP-A1 is not limited thereto, and the first blocking opening OP-A1 may have various planar shapes.

FIG. 8 is an enlarged cross-sectional view of the display panel DP taken along line I-I' of FIG. 4 according to an embodiment of the present disclosure.

FIG. 8 is a blowup of one emissive region PXA in the display region DA (refer to FIG. 7), and the emissive region PXA of FIG. 8 may correspond to one of the first to third emissive regions PXA-R, PXA-G, and PXA-G of FIG. 7. Referring to FIG. 8, the display panel DP may include the base layer BL, the circuit element layer DP-CL, the display element layer DP-OLED, and the thin film encapsulation layer TFE.

Referring to FIG. 8, the display panel DP may include a plurality of insulating layers, a semiconductor pattern, a conductive pattern, a signal line, and the like. An insulating layer, a semiconductor layer, and a conductive layer are formed by (or provided by) coating, deposition, or the like. Thereafter, the insulating layer, the semiconductor layer, and the conductive layer may be selectively subjected to patterning by photolithography and etching to form various patterns within a respective material layer. The semiconductor pattern, the conductive pattern, and the signal line included in the circuit element layer DP-CL and the display element layer DP-OLED may be formed by the above-described method.

The base layer BL may be a base substrate of the display panel DP. The base layer BL may include the display region DA (refer to FIG. 3) including the emissive region PXA and the non-emissive region NPXA, and the non-display region NDA (refer to FIG. 3) which is adjacent to the display region DA (refer to FIG. 3).

The circuit element layer DP-CL may be disposed on the base layer BL. The circuit element layer DP-CL may include a buffer layer BFL, a transistor TR1, a signal transmission region SCL, first to fifth insulating layers 10, 20, 30, 40, and 50, an electrode EE, and a plurality of connecting electrodes CNE1 and CNE2.

The buffer layer BFL may be disposed on the base layer BL. The buffer layer BFL may improve a coupling force between the base layer BL and a semiconductor pattern. The buffer layer BFL may include silicon oxide layers and silicon nitride layers. The silicon oxide layers and the silicon nitride layers may be alternately stacked one above another.

The semiconductor pattern may be disposed on the buffer layer BFL. The semiconductor pattern may include poly-silicon. However, without being limited thereto, the semiconductor pattern may include amorphous silicon or metal oxide. In FIG. 8, a portion of the semiconductor pattern of a semiconductor layer is illustrated as an example, and the semiconductor pattern may be additionally disposed in the plurality of emissive regions PXA-R, PXA-G, PXA-B (refer to FIG. 8). The semiconductor pattern may be arranged across the plurality of emissive regions PXA-R, PXA-G, PXA-B according to a specific rule. The semiconductor pattern may have different electrical properties depending on whether the semiconductor pattern is doped or not. The semiconductor pattern may include a first region having a high doping concentration and a second region having a low doping concentration. The first region may be doped with an N-type dopant or a P-type dopant. A P-type transistor may include a first region doped with a P-type dopant.

The first region has a higher conductivity than the second region and substantially serves as an electrode or a signal line. The second region may substantially correspond to an active (or, channel) region of the transistor. In other words, within a same semiconductor pattern, one portion of the semiconductor pattern may be the active region of the transistor, another portion may be a source or drain of the transistor, and another portion may be a conductive region.

The source S, the active region A, and the drain D of the transistor TR1 may be formed from or be portions of the semiconductor pattern. FIG. 8 illustrates a portion of the signal transmission region SCL formed from the semiconductor pattern. Although not separately illustrated, the signal transmission region SCL may be connected to the drain D of the transistor TR1 on the plane, such as to be respective portions of the semiconductor layer.

The first to fifth insulating layers 10, 20, 30, 40, and 50 may be disposed on the buffer layer BFL. The first to fifth insulating layers 10, 20, 30, 40, and 50 may be inorganic layers or organic layers.

The first insulating layer 10 may be disposed on the buffer layer BFL. The first insulating layer 10 may cover the source S, the active region A, and the drain D of the transistor TR1 and the signal transmission region SCL which are disposed on the buffer layer BFL. A gate G of the transistor TR1 may be disposed on the first insulating layer 10. The second insulating layer 20 may be disposed on the first insulating layer 10 and may cover the gate G. The electrode EE may be disposed on the second insulating layer 20. The third insulating layer 30 may be disposed on the second insulating layer 20 and may cover the electrode EE.

The first connecting electrode CNE1 may be disposed on the third insulating layer 30. The first connecting electrode CNE1 may be connected to the signal transmission region SCL at or through a first contact hole CNT-1 penetrating the first to third insulating layers 10, 20, and 30. The fourth insulating layer 40 may be disposed on the third insulating layer 30 and may cover the first connecting electrode CNE1. The fourth insulating layer 40 may be an organic layer.

The second connecting electrode CNE2 may be disposed on the fourth insulating layer 40. The second connecting electrode CNE2 may be connected to the first connecting electrode CNE1 through a second contact hole CNT-2 penetrating the fourth insulating layer 40. The fifth insulating layer 50 may be disposed on the fourth insulating layer 40 and may cover the second connecting electrode CNE2. The fifth insulating layer 50 may be an organic layer.

The display element layer DP-OLED may be disposed on the circuit element layer DP-CL. The display element layer DP-OLED may include a light emitting element ED, a sacrificial pattern SP, a pixel defining layer PDL, the barrier wall PW, and a dummy pattern DMP.

The light emitting element ED may include an anode AE (or, a first electrode), an emission pattern EP (or, an intermediate layer) disposed on the anode AE, and a cathode CE (or, a second electrode) disposed on the emission pattern EP. The light emitting element ED may overlap a light emitting opening OP-E.

The anode AE may be disposed on the fifth insulating layer 50 of the circuit element layer DP-CL. The anode AE may be a transmissive electrode, a transflective electrode, or a reflective electrode. The anode AE may be connected to the second connecting electrode CNE2 at or through a connection contact hole CNT-3 defined to penetrate the fifth insulating layer 50. Accordingly, the anode AE may be electrically connected to the signal transmission region SCL through the first and second connecting electrodes CNE1 and CNE2 and may be electrically connected to a corresponding circuit element. The anode AE may include a single-layer structure or a multi-layer structure. The anode AE may include a plurality of layers including ITO and Ag. For example, the anode AE may include a layer including ITO (hereinafter, referred to as the lower IOT layer), a layer disposed on the lower IOT layer and including Ag (hereinafter, referred to as the Ag layer), and a layer disposed on the Ag layer and including ITO (hereinafter, referred to as the upper ITO layer).

The sacrificial pattern SP may be disposed between the emission pattern EP and the pixel defining layer PDL, in a planar direction along the circuit element layer DP-CL. A sacrificial opening OP-S which exposes a portion of the upper surface of the anode AE may be defined in the sacrificial pattern SP by an inner sidewall thereof. The sacrificial opening OP-S may overlap the light emitting opening OP-E which will be described below.

The pixel defining layer PDL may be disposed over the base layer BL. In detail, the pixel defining layer PDL may be disposed on the fifth insulating layer 50 of the circuit element layer DP-CL. The pixel defining layer PDL may have or define the light emitting opening OP-E defined therein. The light emitting opening OP-E may correspond to the anode AE, and the pixel defining layer PDL may expose at least a portion of the anode AE to outside the pixel defining layer PDL through the light emitting opening OP-E defined therein.

In addition, the light emitting opening OP-E may correspond to or overlap the sacrificial opening OP-S of the sacrificial pattern SP. According to this embodiment, the upper surface of the anode AE may be spaced apart from a lower surface of the pixel defining layer PDL facing the anode AE in a cross-sectional view, with the sacrificial pattern SP therebetween along a thickness direction (e.g., the third direction DR3). Accordingly, damage to the anode AE in a process of forming the light emitting opening OP-E in a pixel defining material layer may be prevented.

When viewed from above the plane, the area (e.g., the planar area) of the light emitting opening OP-E may be smaller than the area of the sacrificial opening OP-S. That is, the inner surface of the pixel defining layer PDL which defines the light emitting opening OP-E may be closer to the center of the anode AE than the inner surface of the sacrificial pattern SP which defines the sacrificial opening OP-S. However, without being limited thereto, the inner surface of the sacrificial pattern SP which defines the sacrificial opening OP-S may be substantially aligned with the inner surface of the pixel defining layer PDL which defines the light emitting opening OP-E.

The pixel defining layer PDL may include an inorganic insulating material. For example, the pixel defining layer PDL may include silicon nitride SiNₓ. The pixel defining layer PDL may be disposed between the anode AE and the barrier wall PW and may block electrical connection between the anode AE and the barrier wall PW.

The barrier wall PW may be disposed on the pixel defining layer PDL. The barrier wall PW may have or define a barrier wall opening OP-P defined therein. The barrier wall opening OP-P may overlap the light emitting opening OP-E and may expose at least a portion of the anode AE to outside the barrier wall PW.

The barrier wall PW may have an undercut shape on the section (e.g., in cross-section). The barrier wall PW may include multiple layers sequentially stacked one above another. At least one layer among the multiple layers which defines portions the barrier wall opening OP-P may have a sidewall which is recessed relative to a sidewall of the other layers. Accordingly, the barrier wall PW may include or define a tip portion TP.

The barrier wall PW may include a first barrier wall layer L1 and a second barrier wall layer L2. The first barrier wall layer L1 may be disposed on the pixel defining layer PDL, and the second barrier wall layer L2 may be disposed on the first barrier wall layer L1. As illustrated in FIG. 8, the thickness of the first barrier wall layer L1 may be greater than the thickness of the second barrier wall layer L2. However, the present disclosure is not limited thereto.

When compared to the second barrier wall layer L2, a sidewall of the first barrier wall layer L1 which defines a thickness portion of the barrier wall opening OP-P may be relatively recessed in a direction away from the emissive region PXA. The first barrier wall layer L1 may be undercut with respect to the second barrier wall layer L2. The portion of the second barrier wall layer L2 which protrudes from the sidewall of the first barrier wall layer L1 and toward the emissive region PXA may be defined as the tip portion TP within the barrier wall PW. That is, the second barrier wall layer L2 may include or define the tip portion TP of the barrier wall PW which protrudes further from the sidewall of the first barrier wall layer L1 and toward the emissive region PXA.

The length TD of the tip portion TP in the first direction DR1 may correspond to the length from a first inner surface S-L1 of the first barrier wall layer L1 (e.g., a first sidewall) which overlaps the pixel defining layer PDL to a second inner surface S-L2 of the second barrier wall layer L2 (e.g., a second sidewall).

While structures in FIG. 8 are shown along a DR1-DR3 plane, it will e understood that structures may be applied along a DR2-DR3 plane. The barrier wall opening OP-P defined in the barrier wall PW may include a first region AA1 as a first thickness portion or a first volume and a second region AA2 as a second thickness portion or a second volume. The first barrier wall layer L1 may include the first inner surface S-L1 which defines a lower portion of the barrier wall opening OP-P at the first region AA1, and the second barrier wall layer L2 may include the second inner surface S-L2 which defines an upper portion of the barrier wall opening OP-P at the second region AA2. On the section, the second inner surface S-L2 of the second barrier wall layer L2 may be closer to the center of the anode AE than the first inner surface S-L1 of the first barrier wall layer L1. The first inner surface S-L1 may be recessed in a direction away from the center of the anode AE with respect to the second inner surface S-L2. That is, the first inner surface S-L1 may be further from the emissive region PXA than the second inner surface S-L2.

In a planar direction, such as in a direction along the circuit element layer DP-CL, the width of the first region AA1 may be different from the width of the second region AA2. The width of the first region AA1 may be greater than the width of the second region AA2. In this case, the tip portion TP may define the second region AA2 of the barrier wall opening OP-P. Here the tip portion TP may be coplanar with the second region AA2 of the barrier wall opening OP-P.

Each of the first barrier wall layer L1 and the second barrier wall layer L2 may include a conductive material. For example, the conductive material may include metal, transparent conductive oxide (TCO), or a combination thereof. For example, the metal may include gold (Au), silver (Ag), aluminum (Al), magnesium (Mg), lithium (Li), molybdenum (Mo), titanium (Ti), copper (Cu), or an alloy. The transparent conductive oxide may include indium tin oxide (ITO), indium zinc tin oxide (IZTO), indium zinc oxide (IZO), zinc oxide, indium oxide, indium gallium oxide, indium gallium zinc oxide (IGZO), or aluminum zinc oxide.

Although FIG. 8 illustrates an example in which the first inner surface S-L1 and the second inner surface S-L2 are perpendicular to the upper surface of the pixel defining layer PDL, the present disclosure is not limited thereto. For example, the barrier wall PW may have a tapered shape or an inverted tapered shape, owing to an inclined sidewall of the first inner surface S-L1 and/or the second inner surface S-L2 relative to the upper surface of the pixel defining layer PDL.

The emission pattern EP may be disposed on the anode AE and may emit light. The emission pattern EP may include an emissive layer including a luminescent material. The emission pattern EP may further include a hole injection layer (HIL) and a hole transport layer (HTL) which are disposed between the anode AE and the emissive layer and may further include an electron transport layer (ETL) and an electron injection layer (EIL) which are disposed on the emissive layer. The emission pattern EP may be referred to as an "organic layer" or an "intermediate layer".

The emission pattern EP may be patterned and deposited using a fine metal mask (FMM). The emission pattern EP may be disposed in an emission opening defined by the sacrificial opening OP-S, the light emitting opening OP-E, and the barrier wall opening OP-P together with each other. The emission pattern EP may be deposited on an exposed portion of the upper surface of the pixel defining layer PDL which is exposed to the barrier wall opening OP-P. That is, opposite ends of the emission pattern EP may be formed on or extend along exposed portions of the upper surface of the pixel defining layer PDL. The emission pattern EP may be spaced apart from the side surface of the barrier wall PW when viewed from above the plane. For example, the emission pattern EP may be spaced apart from the first inner surface S-L1 of the first barrier wall layer L1 when viewed from above the plane. That is, the emission pattern EP may not make contact with the barrier wall PW.

A p-doped hole injection layer of the hole injection layer included in the emission pattern EP may have conductivity. In this case, if the emission pattern EP is formed to make contact with the barrier wall PW, the barrier wall PW including the conductive material and the emission pattern EP may be electrically connected with each other, and therefore a leakage current may occur. According to the present disclosure, as the emission pattern EP is spaced apart from the barrier wall PW when viewed from above the plane, a leakage current may be prevented from occurring even though a portion (e.g., the p-doped hole injection layer) of the emission pattern EP has conductivity.

The cathode CE may be disposed on the emission pattern EP. At least a portion of the cathode CE may be disposed in the barrier wall opening OP-P. The cathode CE may be deposited on the upper surface of the pixel defining layer PDL which is exposed to the barrier wall opening OP-P. That is, opposite ends of the cathode CE may be formed on the pixel defining layer PDL.

The opposite ends of the cathode CE may make contact with the side surface of the barrier wall PW and may be electrically connected with the barrier wall PW at the side surface of the barrier wall PW. The barrier wall PW may receive the second drive voltage ELVSS (refer to FIG. 5). Accordingly, the cathode CE may be electrically connected to the barrier wall PW and may receive the second drive voltage ELVSS. As being in contact, elements may form an interface therebetween. In an embodiment, an inner surface of the barrier wall layer defines the barrier wall opening, the light emitting element ED includes a first electrode AE, an emission pattern EP on the first electrode AE, and a second electrode CE on the emission pattern EP, and the second electrode CE contacts the inner surface of the barrier wall layer at the barrier wall opening OP-P.

The cathode CE may have conductivity. As long as the cathode CE is capable of having conductivity, the cathode CE may be formed of various materials such as metal, transparent conductive oxide (TCO), or a conductive polymer material. For example, the cathode CE may include silver (Ag), magnesium (Mg), lead (Pb), copper (Cu), or a compound thereof.

Although not illustrated in FIG. 8, a capping pattern may be disposed in the barrier wall opening OP-P. The capping pattern may be disposed on the cathode CE and may protect the cathode CE and the light emitting element ED.

The dummy pattern DMP may be disposed on the barrier wall PW. The dummy pattern DMP may be disposed on the upper surface of the second barrier wall layer L2. The dummy pattern DMP may include a conductive material. The dummy pattern DMP may include the same material as the cathode CE. The dummy pattern DMP may be simultaneously formed with the cathode CE through one process and may be separated from the cathode CE by the undercut shape of the barrier wall PW. That is, the dummy pattern DMP and the cathode CE may be in a same layer of the display element layer DP-OLED as each other.

The thin film encapsulation layer TFE may be disposed on the display element layer DP-OLED. The thin film encapsulation layer TFE may include a lower inorganic encapsulation layer LIL, an organic encapsulation film OL, and an upper inorganic encapsulation layer UIL.

The organic encapsulation film OL may cover the lower inorganic encapsulation layer LIL and may provide a flat upper surface. The upper inorganic encapsulation layer UIL may be disposed on the organic encapsulation film OL.

The lower inorganic encapsulation layer LIL and the upper inorganic encapsulation layer UIL may protect the display element layer DP-OLED from moisture/oxygen, and the organic encapsulation film OL may protect the display element layer DP-OLED from foreign matter such as dust particles.

The permittivity of the organic encapsulation film OL may range from about 2.0 to about 3.2. It may be difficult for the organic encapsulation film OL to have a permittivity of less than about 2.0 due to the material characteristics of the organic encapsulation film OL. When the permittivity of the organic encapsulation film OL is about 3.2 or more, parasitic capacitance existing between the sensor conductive layers IS-CL1 and IS-CL2 and the cathode CE may be increased, and therefore noise may be increased. Due to this, the touch sensitivity of the input sensor INS may be degraded, and touch reliability may be lowered. Accordingly, the permittivity of the organic encapsulation film OL may range from about 2.0 to about 3.2. In an embodiment, the permittivity of the organic encapsulation film OL may range from about 2.0 to about 2.8.

The thickness THO of the organic encapsulation film OL may range from about 0.1 micrometer (µm) to about 20 micrometers (µm).When the thickness THO of the organic encapsulation film OL is less than 0.1 µm, the organic encapsulation film OL may fail to protect the display element layer DP-OLED from foreign matter such as dust particles. The thickness THO of the organic encapsulation film OL may be the distance from the upper surface of the lower inorganic encapsulation layer LIL to the upper surface of the organic encapsulation film OL. When the thickness THO of the organic encapsulation film OL exceeds about 20 µm, the display panel DP may be excessively thick. Since the organic encapsulation film OL has a relatively low permittivity of about 2.0 to about 3.2, excellent touch sensitivity may be maintained even though the thickness of the organic encapsulation film OL is about 20 µm or less. In an embodiment, the thickness THO of the organic encapsulation film OL may be about 0.4 µm or less.

The display module DM may include the input sensor INS. The input sensor INS may be directly disposed on the thin film encapsulation layer TFE. The input sensor INS may include a sensor base layer IS-IL1, the first sensor conductive layer IS-CL1, a first sensor insulating layer IS-IL2, the second sensor conductive layer IS-CL2, and a second sensor insulating layer IS-IL3. The sensor base layer IS-IL1 may be directly disposed on the upper inorganic encapsulation layer UIL. The first sensor conductive layer IS-CL1 may be disposed on the sensor base layer IS-IL1. The first sensor insulating layer IS-IL2 may be disposed on the first sensor conductive layer IS-CL1 and may cover the first sensor conductive layer IS-CL1. The second sensor conductive layer IS-CL2 may be disposed on the first sensor insulating layer IS-IL2. The second sensor insulating layer IS-IL3 may be disposed on the second sensor conductive layer IS-CL2 and may cover the second sensor conductive layer IS-CL2. The second sensor conductive layer IS-CL2 may be connected with the first sensor conductive layer IS-CL1 through a sensor contact hole penetrating the first sensor insulating layer IS-IL2.

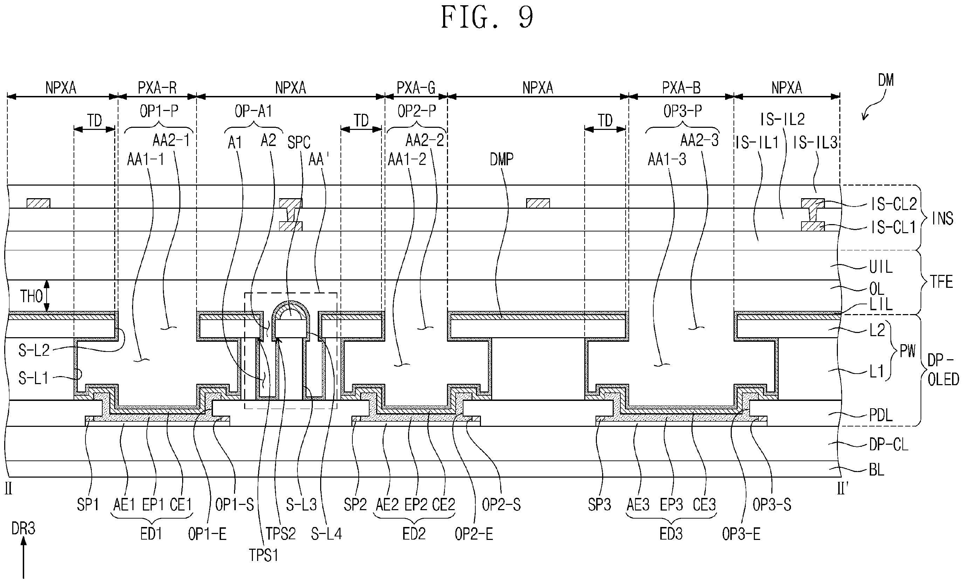

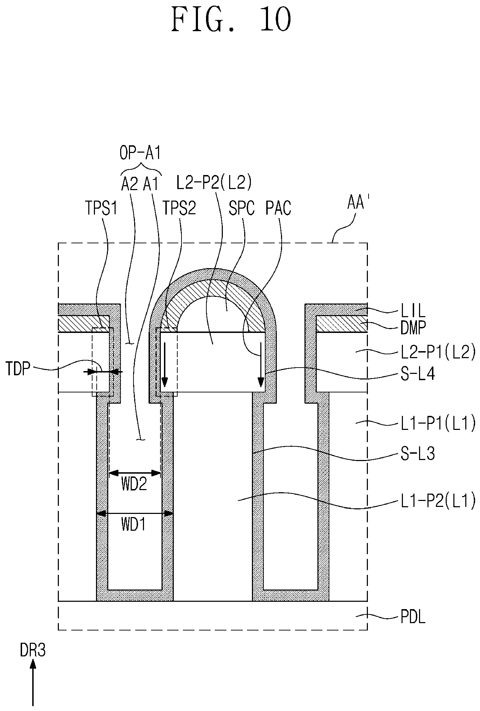

FIG. 9 is a sectional view taken along line II-II' of FIG. 7 according to an embodiment of the present disclosure. FIG. 10 is an enlarged sectional view illustrating region AA' of FIG. 9 according to an embodiment of the present disclosure.

FIG. 9 is an enlarged view illustrating one first emissive region PXA-R, one second emissive region PXA-G, and one third emissive region PXA-B, and the description of the emissive region PXA of FIG. 8 may be identically applied to each of the first to third emissive regions PXA-R, PXA-G, and PXA-B.

Referring to FIG. 9, the display panel DP according to this embodiment may include the base layer BL, the circuit element layer DP-CL, the display element layer DP-OLED, and the thin film encapsulation layer TFE. The display element layer DP-OLED may include light emitting elements ED1, ED2, and ED3, sacrificial patterns SP1, SP2, and SP3, the pixel defining layer PDL, the barrier wall PW, and dummy patterns DMP.

The light emitting elements ED1, ED2, and ED3 may include the first light emitting element ED1, the second light emitting element ED2, and the third light emitting element ED3. The first light emitting element ED1 may overlap a first light emitting opening OP1-E. The second light emitting element ED2 may overlap a second light emitting opening OP2-E. The third light emitting element ED3 may overlap a third light emitting opening OP3-E.

The first light emitting element ED1 may include a first anode AE1, a first emission pattern EP1, and a first cathode CE1. The second light emitting element ED2 may include a second anode AE2, a second emission pattern EP2, and a second cathode CE2. The third light emitting element ED3 may include a third anode AE3, a third emission pattern EP3, and a third cathode CE3. The first to third anodes AE1, AE2, and AE3 may be provided in a plurality of patterns, that is, discrete patterns or island shaped patterns. In an embodiment, the first emission pattern EP1 may provide red light, the second emission pattern EP2 may provide green light, and the third emission pattern EP3 may provide blue light.

The first to third light emitting openings OP1-E, OP2-E, and OP3-E may be defined in the pixel defining layer PDL. The first light emitting opening OP1-E may expose at least a portion of the first anode AE1 to outside the pixel defining layer PDL. The second light emitting opening OP2-E may expose at least a portion of the second anode AE2 to outside the pixel defining layer PDL. The third light emitting opening OP3-E may expose at least a portion of the third anode AE3 to outside the pixel defining layer PDL.

The sacrificial patterns SP1, SP2, and SP3 may include the first sacrificial pattern SP1, the second sacrificial pattern SP2, and the third sacrificial pattern SP3. The first to third sacrificial patterns SP1, SP2, and SP3 may be disposed on the upper surfaces of the first to third anodes AE1, AE2, and AE3, respectively. First to third sacrificial openings OP1-S, OP2-S, and OP3-S overlapping the first to third light emitting openings OP1-E, OP2-E, and OP3-E may be defined in the first to third sacrificial patterns SP1, SP2, and SP3, respectively.

In this embodiment, first to third barrier wall openings OP1-P, OP2-P, and OP3-P overlapping the first to third light emitting openings OP1-E, OP2-E, and OP3-E, respectively, may be defined in the barrier wall PW. The first emissive region PXA-R may be defined as a region of the upper surface of the first anode AE1 exposed by the first barrier wall opening OP1-P. The second emissive region PXA-G may be defined as a region of the upper surface of the second anode AE2 exposed by the second barrier wall opening OP2-P. The third emissive region PXA-B may be defined as a region of the upper surface of the third anode AE3 exposed by the third barrier wall opening OP3-P. The emissive region PXA may be a minimum width of the barrier wall opening OP-P, without being limited thereto.

The first to third barrier wall openings OP1-P, OP2-P, and OP3-P may include first regions AA1-1, AA1-2, and AA1-3 corresponding to the first region AA1 (refer to FIG. 8) described above with reference to FIG. 8 and second regions AA2-1, AA2-2, and AA2-3 corresponding to the second region AA2 (refer to FIG. 8) described above with reference to FIG. 8. The first barrier wall layer L1 may include first inner surfaces S-L1 (refer to FIG. 8) which define the first regions AA1-1, AA1-2, and AA1-3 of the first to third barrier wall openings OP1-P, OP2-P, and OP3-P, and the second barrier wall layer PL2 may include second inner surfaces S-L2 (refer to FIG. 8) which define the second regions AA2-1, AA2-2, and AA2-3 of the first to third barrier wall openings OP1-P, OP2-P, and OP3-P.

The first emission pattern EP1 and the first cathode CE1 may be disposed in the first barrier wall opening OP1-P, the second emission pattern EP2 and the second cathode CE2 may be disposed in the second barrier wall opening OP2-P, and the third emission pattern EP3 and the third cathode CE3 may be disposed in the third barrier wall opening OP3-P.

A material layer for providing the first to third emission patterns EP1, EP2, and EP3 may be subjected to patterning using a fine metal mask (FMM). The first to third emission patterns EP1, EP2, and EP3 may be spaced apart from the barrier wall PW when viewed from above the plane, that is, in a direction along the circuit element layer DP-CL. That is, the first to third emission patterns EP1, EP2, and EP3 may not make contact with the first inner surfaces S-L1 of the first barrier wall layer L1.

According to this embodiment, since the barrier wall PW is included, the physical separation between the light emitting elements ED1, ED2, and ED3 may be easily achieved. Accordingly, current leakage or a driving error between the adjacent emissive regions PXA-R, PXA-G, and PXA-B may be prevented, and the light emitting elements ED1, ED2, and ED3 may be independently driven.

In an embodiment of a method of providing the display panel DP, a material layer for providing the cathode CE may be commonly formed or provided using an open mask, but the pattern of the cathode CE may be separated from the pattern of the dummy pattern DMP by a structure of the barrier wall PW along which the material layer is provided.

The thin film encapsulation layer TFE may include the lower inorganic encapsulation layer LIL, the organic encapsulation film OL, and the upper inorganic encapsulation layer UIL. The lower inorganic encapsulation layer LIL may cover the first to third light emitting elements ED1, ED2, and ED3 and the first to third cathodes CE1, CE2, and CE3. The lower inorganic encapsulation layer LIL may cover the dummy patterns DMP. Portions of the lower inorganic encapsulation layer LIL may be disposed in the first to third barrier wall openings OP1-P, OP2-P, and OP3-P, respectively.

The lower inorganic encapsulation layer LIL may extend along the first inner surfaces S-L1 and the second inner surfaces S-L2 which define the barrier wall openings OP1-P, OP2-P, and OP3-P.

The organic encapsulation film OL may cover the lower inorganic encapsulation layer LIL, may fill volumes of the barrier wall openings OP-P, and may provide a flat upper surface. The upper inorganic encapsulation layer UIL may be disposed on the organic encapsulation film OL.

Referring to FIGS. 9 and 10, the spacer SPC may be disposed on the second barrier wall layer L2 and may not overlap the light emitting openings OP1-E, OP2-E, and OP3-E. The spacer SPC may overlap the non-emissive region NPXA. The spacer SPC may be disposed at a portion of the non-emissive region NPXA among the first to third emissive regions PXA-R, PXA-G, and PXA-B which are adjacent to each other. The spacer SPC may be surrounded by the first blocking opening OP-A1. The space SPC may have a shape protruding from an upper surface of the second barrier wall layer L2, in the third direction DR3. When the emission patterns EP1, EP2, and EP3 are subjected to patterning using a fine metal mask, the spacer SPC may support the fine metal mask.

The first blocking opening OP-A1 surrounding the spacer SPC may be defined in the barrier wall PW. The first blocking opening OP-A1 may include a first opening portion A1 and a second opening portion A2. The first barrier wall layer L1 may include a third inner surface S-L3 which defines the first opening portion A1 as a lower portion of the first blocking opening OP-A1. The second barrier wall layer L2 may include a fourth inner surface S-L4 which defines the second opening portion A2 of the first blocking opening OP-A1. On the section, the fourth inner surface S-L4 of the second barrier wall layer L2 may be closer to the center of the spacer SPC than the third inner surface S-L3 of the first barrier wall layer L1, such as to define a protruded portion of the second barrier wall layer L2 at the first blocking opening OP-A1. The third inner surface S-L3 may be recessed in a direction away from the center of the spacer SPC with respect to the fourth inner surface S-L4.

The barrier wall layer (e.g., the barrier wall PW) may include a main barrier wall between adjacent light emission areas, and a sub-barrier wall defined with the main barrier wall. The spacer SPC may correspond to the sub-barrier wall which is separated from portions of the main barrier wall, by a gap defined by a first blocking opening OP-A1.

The first barrier wall layer L1 may be divided into a first portion L1-P1 and a second portion L1-P2 by the first blocking opening OP-A1. The second portion L1-P2 may be spaced apart and isolated from the first portion L1-P1. The second barrier wall layer L2 may be divided into a first portion L2-P1 and a second portion L2-P2 by the first blocking opening OP-A1. The second portion L2-P2 may be spaced apart and isolated from the first portion L2-P1. That is, the spacer SPC, the second portion L1-P2 of the first barrier wall layer L1, and the second portion L2-P2 of the second barrier wall layer L2 may be isolated from other portions of the barrier wall PW, by the first blocking opening OP-A1 as a gap. Referring to FIG. 10, for example, the barrier wall which has the spacer SPC thereon (e.g., left and right portions of L1-P1 and L2-P1 together with L1-P2 and L2-P2 making up a barrier wall) defines a blocking opening OP-A1 of the barrier wall which surrounds the spacer SPC. Accordingly, even though foreign matter PAC may be introduced into the spacer SPC, the second portion L1-P2 of the first barrier wall layer L1, and the second portion L2-P2 of the second barrier wall layer L2, the foreign matter PAC may not be able to move to the light emitting elements ED1, ED2, and ED3, owing to the gap at the first blocking opening OP-A1.

The sub-barrier wall within the first blocking opening OP-A1 of the barrier wall PW may have an undercut shape on the section. The second barrier wall layer L2 may include blocking tip portions TPS1 and TPS2 protruding toward the first blocking opening OP-A1 with respect to the first barrier wall layer L1. The blocking tip portions TPS1 and TPS2 may include the first blocking tip portion TPS1 at the first opening portion A1 and the second blocking tip portion TPS2 at the second opening portion A2. The first blocking tip portion TPS1 may be a portion of the first portion L2-P1 of the second barrier wall layer L2 which protrudes toward the first blocking opening OP-A1 with respect to the first portion L1-P1 of the first barrier wall layer L1. The second blocking tip portion TPS2 may be a portion of the second portion L2-P2 of the second barrier wall layer L2 which protrudes toward the first blocking opening OP-A1 with respect to the second portion L1-P2 of the first barrier wall layer L1. Here, the barrier wall layer further includes among the barrier walls, a first barrier wall layer L1 and a second barrier wall layer L2 which is on the first barrier wall layer L1, and at the first blocking opening OP-A1, the second barrier wall layer L2 protruding further than the first barrier wall layer L1 and defining the blocking tip portion TPS1 and TPS2 at the second barrier wall layer L2.

The protruding lengths TDP of the first and second blocking tip portions TPS1 and TPS2 may be shorter than the length TD of the tip portion TP (refer to FIG. 8). The protruding lengths TDP may be shorter than the length TD since an etchant flows into the second opening portion A2 of the first blocking opening OP-A1 at a low speed in a wet etching process, which will be described below, due to a second width WD2 as a narrow width at the inlet of the second opening portion A2 so that a side surface of the second barrier layer L2 is exposed to the etchant for a short period of time.

The first blocking opening OP-A1 may block foreign matter remaining on the spacer SPC, foreign matter introduced due to a dent in the spacer SPC, and moisture (hereinafter, referred to as the foreign matter PAC) from moving to the light emitting elements ED1, ED2, and ED3. The foreign matter PAC is likely to be introduced due to a dent in a portion adjacent to the spacer SPC, but the introduced foreign matter PAC may be surrounded and isolated by the first blocking opening OP-A1 around the sub-barrier wall. In addition, a path along which the introduced foreign matter PAC reaches the light emitting elements ED1, ED2, and ED3 may be lengthened by the first blocking opening OP-A1. Accordingly, the introduced foreign matter PAC may not be able to pass through layers at the first blocking opening OP-A1 and may not be able to reach the light emitting elements ED1, ED2, and ED3.

The first and second blocking tip portions TPS1 and TPS2 may effectively block the foreign matter PAC introduced through a portion adjacent to the spacer SPC from reaching the light emitting elements ED1, ED2, and ED3. The foreign matter PAC may move along the inner surfaces S-L3 and S-L4 of the barrier wall PW. Thereafter, the foreign matter PAC may be blocked by the first and second blocking tip portions TPS1 and TPS2 at the inlet of the first blocking opening OP-A1 and may not be able to move any more especially to outside the first blocking opening OP-A1. That is, as the path from the spacer SPC to the light emitting elements ED1, ED2, and ED3 is lengthened by the first blocking opening OP-A1, the foreign matter PAC may not be able to move to the light emitting elements ED1, ED2, and ED3. In addition, while moving to the light emitting elements ED1, ED2, and ED3, the foreign matter PAC may be blocked by the first and second blocking tip portions TPS1 and TPS2 and may not be able to move to the light emitting elements ED1, ED2, and ED3.

The first width WD1 of a gap between the sub-barrier wall and the main barrier wall at the first opening portion A1 may be greater than the second width WD2 of a gap between the sub-barrier wall and the main barrier wall at the second opening portion A2. In this case, the second opening portion A2 of the barrier wall PW may be a region which defines the blocking tip portions TPS1 and TPS2. Here, a first opening portion A1 has a width, a second opening portion A2 has a width and is further from the light emitting element ED than the first opening portion A1, and the width of the first opening portion A1 greater than the width of the second opening portion A2.

The second width WD2 of the second opening portion A2 may be about 0.1 µm or more. When the second width WD2 of the second opening portion A2 is less than 0.1 µm, the organic material constituting the organic encapsulation film OL may not be able to flow into the first blocking opening OP-A1 in the process of manufacturing or forming the display panel DP, and therefore the organic encapsulation film OL may not be able to be disposed in the first blocking opening OP-A1.

The lower inorganic encapsulation layer LIL may extend along the inner surfaces S-L3 and S-L4 of the barrier wall PW which define the first blocking opening OP-A1. The lower inorganic encapsulation layer LIL may seamlessly extend into the barrier wall openings OP1-P, OP2-P, and OP3-P and in the first blocking opening OP-A1. The organic encapsulation film OL may be disposed in the first blocking opening OP-A1. Here, an inner surface of the barrier wall layer defines the blocking opening, the lower inorganic encapsulation layer LIL extends along the inner surface of the barrier wall layer which defines the blocking opening, and the organic encapsulation film OL extends along the lower inorganic encapsulation layer LIL and into the blocking opening.

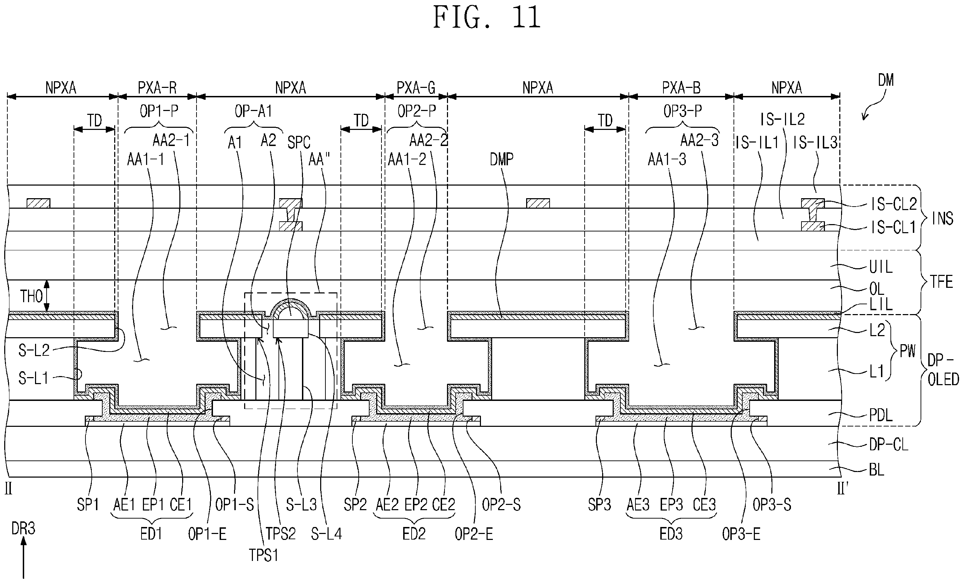

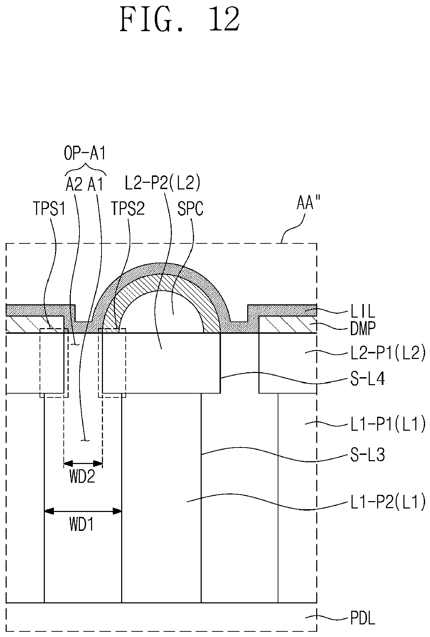

FIG. 11 is a sectional view taken along line II-II' of FIG. 7 according to an embodiment of the present disclosure. FIG. 12 is an enlarged sectional view illustrating region AA" of FIG. 11 according to an embodiment of the present disclosure. Hereinafter, components identical or similar to the components described with reference to FIGS. 9 and 10 will be assigned with identical or similar reference numerals and will be omitted from the description or will be briefly described.

The display panel DP illustrated in FIGS. 11 and 12 may be the same as the display panel DP described with reference to FIGS. 9 and 10, except for the shape of the first blocking opening OP-A1 and the shape of the lower inorganic encapsulation layer LIL.

Referring to FIGS. 11 and 12, the first blocking opening OP-A1 surrounding the spacer SPC may be defined in the barrier wall PW. The first blocking opening OP-A1 may include the first opening portion A1 and the second opening portion A2. The first barrier wall layer L1 may include the third inner surface S-L3 which defines the first opening portion A1 of the first blocking opening OP-A1. The second barrier wall layer L2 may include the fourth inner surface S-L4 which defines the second opening portion A2 of the first blocking opening OP-A1. On the section, the fourth inner surface S-L4 of the second barrier wall layer L2 may be closer to the center of the spacer SPC than the third inner surface S-L3 of the first barrier wall layer L1.

The lower inorganic encapsulation layer LIL may cover and seal the first blocking opening OP-A1 at the inlet thereof. The inlet may be defined as an uppermost portion of the first blocking opening OP-A1. The lower inorganic encapsulation layer LIL may be spaced apart from the third inner surface S-L3 of the first barrier wall layer L1 and the fourth inner surface S-L4 of the second barrier wall layer L2, such as in a planar direction. The gap at the first blocking opening OP-A1 may be surrounded and sealed by the lower inorganic encapsulation layer LIL, together with the first barrier wall layer L1, the second barrier wall layer L2, and the pixel defining layer PDL. The organic encapsulation film OL may not be disposed in the first blocking opening OP-A1 owing to the lower inorganic encapsulation layer LIL which covers and seals the first blocking opening OP-A1 at the inlet thereof.

The first blocking opening OP-A1 may be filled with air. The permittivity of air may be about 1.0 and may be lower than the permittivity of the organic encapsulation film OL. Accordingly, the parasitic capacitance existing between the sensor conductive layers IS-CL1 and IS-CL2 and the cathode CE may be decreased so that noise may be reduced, and thus the touch sensitivity of the input sensor INS may be improved. Here, the blocking opening is open to outside the barrier wall layer at an inlet, the lower inorganic encapsulation layer LIL extends across the inlet and covers and seals the blocking opening, and the blocking opening which is sealed by the lower inorganic encapsulation layer LIL is filled with air.

The first width WD1 of the first opening portion A1 may be greater than the second width WD2 of the second opening portion A2. In this case, the second opening portion A2 of the barrier wall PW may be a region which defines the blocking tip portions TPS1 and TPS2.

The second width WD2 of the second opening portion A2 may be about 1 µm or less. When the second width WD2 of the second opening portion A2 exceeds about 1 µm, the inorganic material constituting the lower inorganic encapsulation layer LIL and the organic material constituting the organic encapsulation film OL may be introduced into the first blocking opening OP-A1 in the process of manufacturing or providing the display panel DP. Therefore, where the second width WD2 of the second opening portion A2 exceeds about 1 µm it is impossible to fill the first blocking opening OP-A1 with air. When the first blocking opening OP-A1 is filled with the organic encapsulation film OL having a higher permittivity than air, the parasitic capacitance existing between the sensor conductive layers IS-CL1 and IS-CL2 and the cathode CE may be increased so that noise may be increased, and therefore the touch sensitivity of the input sensor INS may be degraded.

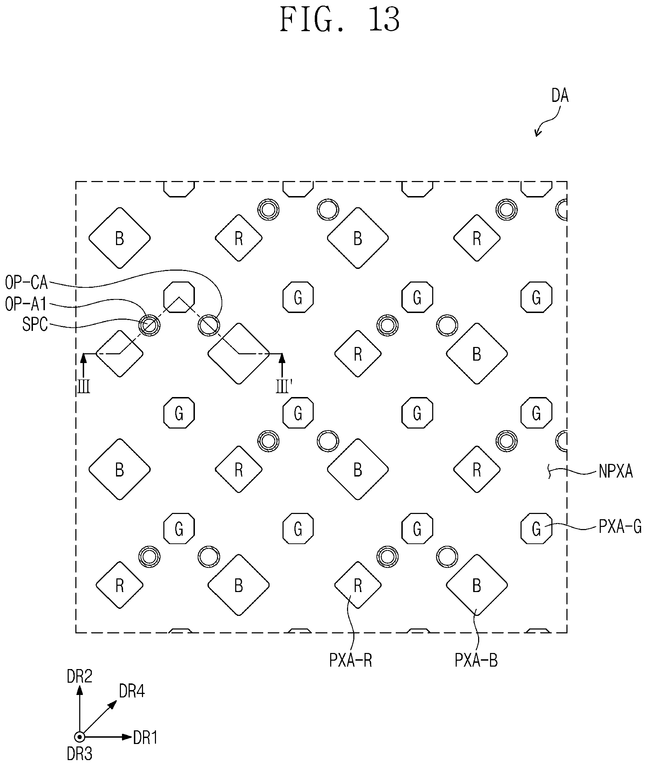

FIG. 13 is an enlarged plan view of a portion of the display region DA of the display module DM according to an embodiment of the present disclosure. Hereinafter, components identical or similar to the components described with reference to FIG. 7 will be assigned with identical or similar reference numerals and will be omitted from the description or will be briefly described.

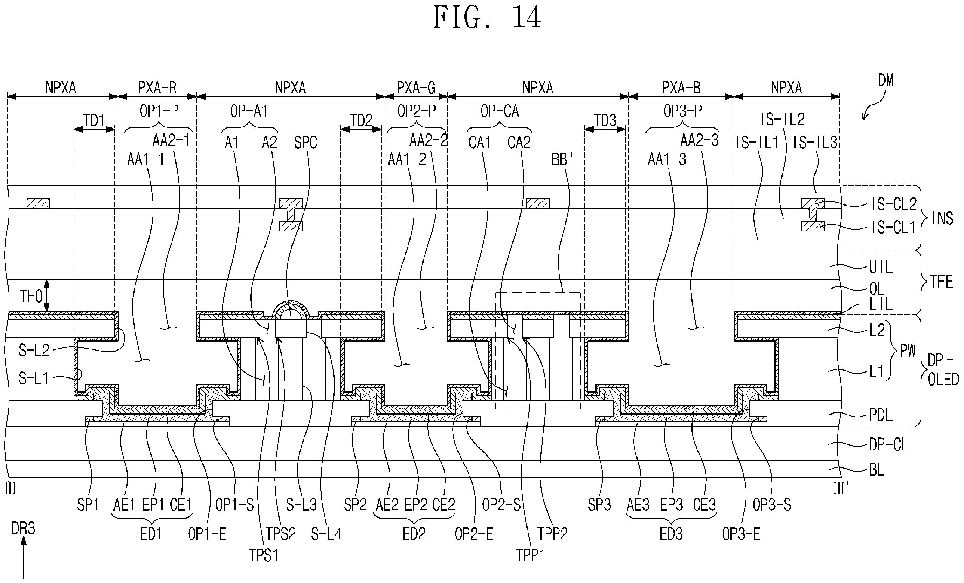

Referring to FIG. 13, an opening OP-CA as a second blocking opening (e.g., a second opening around a second sub-barrier wall) may not overlap the emissive regions PXA-R, PXA-G, and PXA-B and the first blocking opening OP-A1 (e.g., a first opening around a first sub-barrier wall). The opening OP-CA may be defined in the barrier wall PW (refer to FIG. 14). The opening OP-CA may be located among the first to third emissive regions PXA-R, PXA-G, and PXA-B. The opening OP-CA may be disposed between the second emissive region PXA-G and the third emissive region PXA-B. However, the position of the opening OP-CA is not limited thereto, and the opening OP-CA may be disposed in various positions. For example, the opening OP-CA may be disposed between the first emissive region PXA-R and the third emissive region PXA-B in the first direction DR1.

The opening OP-CA may have the same shape as the first blocking opening OP-A1 when viewed from above the plane. However, the shape of the opening OP-CA is not limited thereto, and the opening OP-CA may have various shapes.

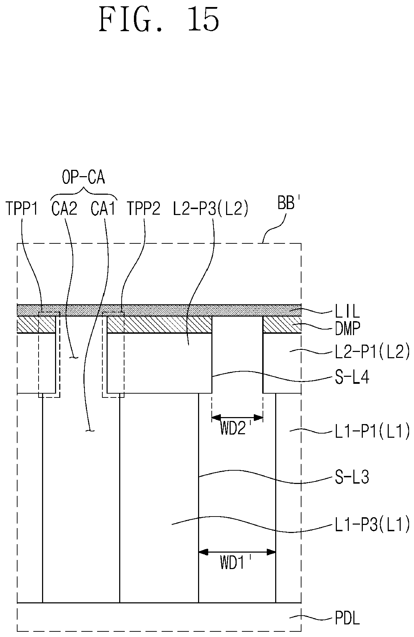

FIG. 14 is a sectional view taken along line III-III' of FIG. 13 according to an embodiment of the present disclosure. FIG. 15 is an enlarged sectional view illustrating region BB' of FIG. 14 according to an embodiment of the present disclosure. The display panel DP to be described with reference to FIGS. 14 and 15 may be the same as the display panel DP described with reference to FIGS. 11 and 12, except for the opening OP-CA. Hereinafter, components identical or similar to the components described with reference to FIGS. 11 and 12 will be assigned with identical or similar reference numerals and will be omitted from the description or will be briefly described.

Referring to FIGS. 14 and 15, the barrier wall PW may have the opening OP-CA defined therein to overlap the non-emissive region NPXA and so as not to overlap the first blocking opening OP-A1 and the light emitting openings OP1-E, OP2-E, and OP3-E. The opening OP-CA may include a first peripheral opening portion CA1 and a second peripheral opening portion CA2. The first peripheral opening portion CA1 and the second peripheral opening portion CA2 of the opening OP-CA may have the same shape as the first opening portion A1 and the second opening portion A2 of the first blocking opening OP-A1 and may be formed through the same process as the first opening portion A1 and the second opening portion A2 of the first blocking opening OP-A1.

At the second sub-barrier wall, the first barrier wall layer L1 may be divided into the first portion L1-P1 and a third portion L1-P3 by the opening OP-CA. The third portion L1-P3 may be spaced apart and isolated from the first portion L1-P1. The second barrier wall layer L2 may be divided into the first portion L2-P1 and a third portion L2-P3 by the opening OP-CA. The third portion L2-P3 may be spaced apart and isolated from the first portion L2-P1. That is, the third portion L1-P3 of the first barrier wall layer L1 and the third portion L2-P3 of the second barrier wall layer L2 may be isolated by the opening OP-CA.

The opening OP-CA of the barrier wall PW which is defined between a main barrier wall and a sub-barrier wall may have an undercut shape on the section. The second barrier wall layer L2 may include peripheral tip portions TPP1 and TPP2 protruding toward the opening OP-CA with respect to the first barrier wall layer L1. The peripheral tip portions TPP1 and TPP2 may include the first peripheral tip portion TPP1 and the second peripheral tip portion TPP2. The first peripheral tip portion TPP1 may be a portion of the first portion L2-P1 of the second barrier wall layer L2 which protrudes toward the opening OP-CA with respect to the first portion L1-P1 of the first barrier wall layer L1. The second peripheral tip portion TPP2 may be a portion of the third portion L2-P3 of the second barrier wall layer L2 which protrudes toward the opening OP-CA with respect to the third portion L1-P3 of the first barrier wall layer L1.

The lower inorganic encapsulation layer LIL may cover and seal the opening OP-CA at the inlet thereof. The lower inorganic encapsulation layer LIL may be spaced apart from the inner surface of the first barrier wall layer L1 and the inner surface of the second barrier wall layer L2. The opening OP-CA may be surrounded and sealed by the lower inorganic encapsulation layer LIL, together with the first barrier wall layer L1, the second barrier wall layer L2, and the pixel defining layer PDL. The organic encapsulation film OL may not be disposed in the opening OP-CA. The opening OP-CA may be filled with air. Referring to FIG. 14, for example, the barrier wall layer further includes among the barrier walls a first barrier wall which has the spacer SPC thereon and defines the blocking opening, a second barrier wall defining an opening of the second barrier wall which is spaced apart from both the light emitting opening and the blocking opening and is open to outside the barrier wall layer at an inlet, the lower inorganic encapsulation layer LIL extends across the inlet and covers and seals the opening, and the opening which is sealed by the lower inorganic encapsulation layer LIL is filled with air.

The permittivity of air may be about 1.0 and may be lower than the permittivity of the organic encapsulation film OL. Accordingly, the parasitic capacitance existing between the sensor conductive layers IS-CL1 and IS-CL2 and the cathode CE may be decreased so that noise may be reduced, and thus the touch sensitivity of the input sensor INS may be improved.

The third width WD1' of the first peripheral opening portion CA1 may be greater than the fourth width WD2' of the second peripheral opening portion CA2. In this case, the second peripheral opening portion CA2 of the barrier wall PW may be a region which defines the peripheral tip portions TPP1 and TPP2.

The fourth width WD2' of the second peripheral opening portion CA2 may be about 1 µm or less. When the fourth width WD2' of the second peripheral opening portion CA2 exceeds about 1 µm, the inorganic material constituting the lower inorganic encapsulation layer LIL and the organic material constituting the organic encapsulation film OL may be introduced into the opening OP-CA in the manufacturing process of the display panel DP. Therefore, it is impossible to fill the opening OP-CA with air. When the opening OP-CA is filled with the organic encapsulation film OL having a higher permittivity than air, the parasitic capacitance existing between the sensor conductive layers IS-CL1 and IS-CL2 and the cathode CE may be increased so that noise may be increased, and therefore the touch sensitivity of the input sensor INS may be degraded.

That is, by filling the first blocking opening OP-A1 and the opening OP-CA with air, the entire parasitic capacitance and noise may be reduced, and thus the touch sensitivity of the input sensor INS may be improved.

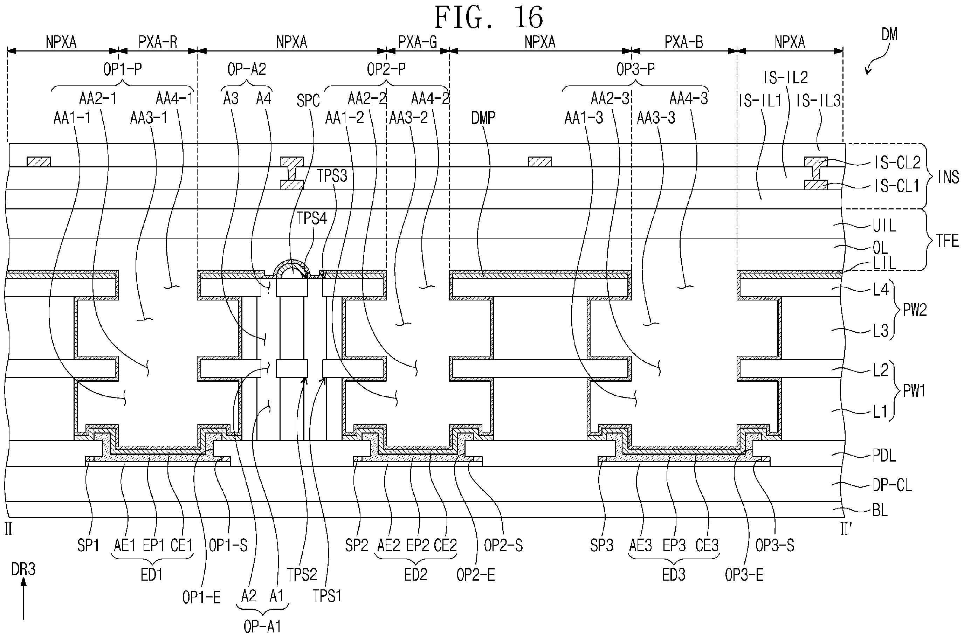

FIG. 16 is a sectional view taken along line II-II' of FIG. 7 according to an embodiment of the present disclosure. Hereinafter, components identical or similar to the components described above will be assigned with identical or similar reference numerals and will be omitted from the description or will be briefly described.

Referring to FIG. 16, a barrier wall PW may be formed in a two-stage structure. The barrier wall PW may include a first barrier wall PW1 together with a second barrier wall PW2. The first barrier wall PW1 may include a first barrier wall layer L1 and a second barrier wall layer L2. The second barrier wall PW2 may include a third barrier wall layer L3 and a fourth barrier wall layer L4. The third barrier wall layer L3 may be disposed on the second barrier wall layer L2. The fourth barrier wall layer L4 may be disposed on the third barrier wall layer L3.

A first barrier wall opening OP1-P may include a first region AA1-1, a second region AA2-1, a third region AA3-1, and a fourth region AA4-1 in communication with each other. A second barrier wall opening OP2-P may include a first region AA1-2, a second region AA2-2, a third region AA3-2, and a fourth region AA4-2 in communication with each other. A third barrier wall opening OP3-P may include a first region AA1-3, a second region AA2-3, a third region AA3-3, and a fourth region AA4-3 in communication with each other.

A first blocking opening OP-A1 may be defined in the first barrier wall PW1. A second blocking opening OP-A2 may be defined in the second barrier wall PW2. The first blocking opening OP-A1 and the second blocking opening OP-A2 may surround a spacer SPC on a first sub-barrier wall, when viewed from above the plane. The second blocking opening OP-A2 may extend from the first blocking opening OP-A1 in the third direction DR3, that is, to be in communication therewith. A lower end of the second blocking opening OP-A2 may be connected with an upper end of the first blocking opening OP-A1. The second blocking opening OP-A2 may include a third opening portion A3 defined in the third barrier wall layer L3 and a fourth opening portion A4 defined in the fourth barrier wall layer L4. Here, the barrier wall layer includes a first barrier wall layer, a second barrier wall layer, a third barrier wall layer and a fourth barrier wall layer in order from the pixel defining layer PDL, and the first barrier wall layer, the second barrier wall layer, the third barrier wall layer and the fourth barrier wall layer define the blocking opening which surrounds the spacer SPC.

The first blocking opening OP-A1 of the first barrier wall PW1 may have an undercut shape on the section. The second barrier wall layer L2 may include first and second blocking tip portions TPS1 and TPS2 protruding toward the first blocking opening OP-A1 with respect to the first barrier wall layer L1.

The second blocking opening OP-A2 of the second barrier wall PW2 may have an undercut shape on the section. The fourth barrier wall layer L4 may include third and fourth blocking tip portions TPS3 and TPS4 protruding toward the second blocking opening OP-A2 with respect to the third barrier wall layer L3. Here, at the blocking opening, the second barrier wall layer L2 protrudes further than the first barrier wall layer L1 and defines a first blocking tip portion at the second barrier wall layer L2, and the fourth barrier wall layer L4 protrudes further than the third barrier wall layer L3 and defines a second blocking tip portion at the fourth barrier wall layer L4.

Since the first blocking opening OP-A1 and the second blocking opening OP-A2 surround the spacer SPC as described above, a path along which foreign matter introduced due to a dent in the spacer SPC reaches the light emitting elements ED1, ED2, and ED3 may be lengthened. In addition, the first to fourth blocking tip portions TPS1, TPS2, TPS3, and TPS4 may effectively block foreign matter introduced through an inlet portion adjacent to the spacer SPC from reaching the light emitting elements ED1, ED2, and ED3. The movement of the foreign matter introduced through the portion adjacent to the spacer SPC may be blocked or limited by the first to fourth blocking tip portions TPS1, TPS2, TPS3, and TPS4 and may not be able to move any more.

Referring to FIG. 16, the lower inorganic encapsulation layer LIL may cover and seal the top of the second blocking opening OP-A2. The first blocking opening OP-A1 and the second blocking opening OP-A2 may be surrounded and sealed by the lower inorganic encapsulation layer LIL, the first to fourth barrier wall layers L1, L2, L3, and L4, and the pixel defining layer PDL. The first blocking opening OP-A1 and the second blocking opening OP-A2 may be filled with air. Since air has a low permittivity, the parasitic capacitance existing between the sensor conductive layers IS-CL1 and IS-CL2 and the cathode CE may be decreased so that noise may be reduced, and thus the touch sensitivity of the input sensor INS may be improved.

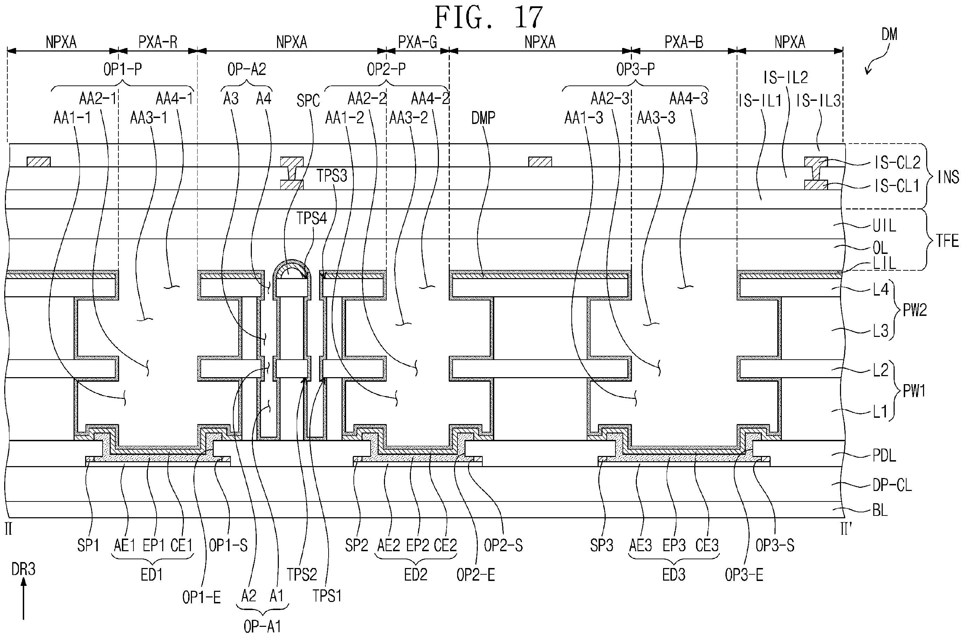

FIG. 17 is a sectional view taken along line II-II' of FIG. 7 according to an embodiment of the present disclosure. Hereinafter, components identical or similar to the components described with reference to FIG. 16 will be assigned with identical or similar reference numerals and will be omitted from the description or will be briefly described.

Referring to FIG. 17, the organic encapsulation film OL may be disposed in the first blocking opening OP-A1 and the second blocking opening OP-A2. The organic encapsulation film OL may extend along the inner surfaces of the first and second barrier wall layers L1 and L2 which define the first blocking opening OP-A1. The organic encapsulation film OL may extend along the inner surfaces of the third and fourth barrier wall layers L3 and L4 which define the second blocking opening OP-A2.

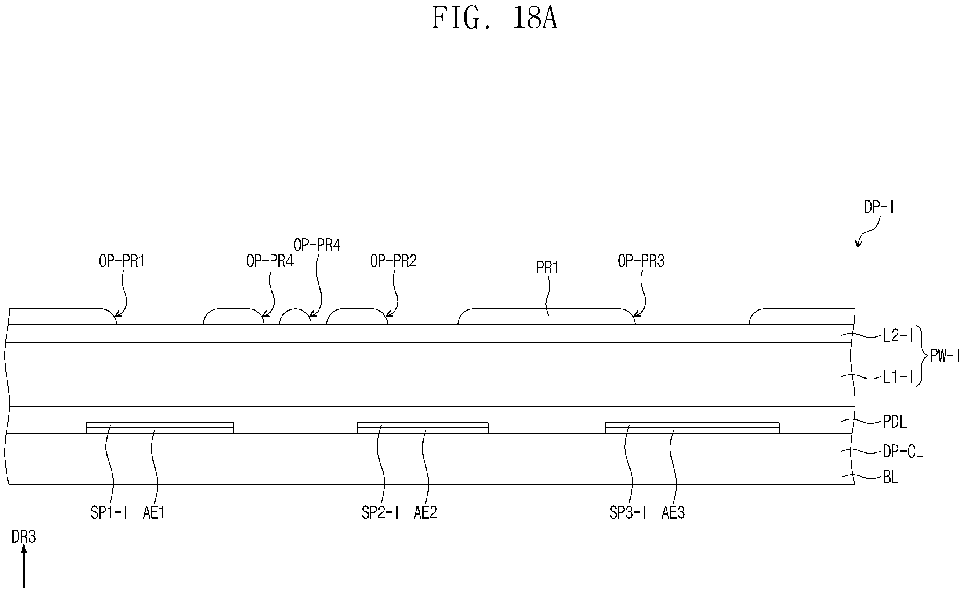

FIGS. 18A to 18H are cross-sectional views illustrating processes in a method of providing (or manufacturing) a display panel DP according to an embodiment of the present disclosure. In describing FIGS. 18A to 18H, components identical or similar to the components described with reference to FIGS. 1 to 17 will be assigned with identical or similar reference numerals, and repetitive descriptions will be omitted.

Referring to FIG. 18A, the method according to this embodiment may include providing a preliminary display panel DP-I. The preliminary display panel DP-I provided in this embodiment may include the base layer BL, the circuit element layer DP-CL, the first, second and third anodes AE1, AE2 and AE3, first, second and third preliminary sacrificial patterns SP1-I, SP2-I and SP-3I, the pixel defining layer PDL, a first preliminary barrier wall layer L1-I, and a second preliminary barrier wall layer L2-I.

The circuit element layer DP-CL may be formed through a circuit element manufacturing process of forming (or providing) an insulating layer, a semiconductor layer, and a conductive layer by coating, deposition, or the like and forming a semiconductor pattern, a conductive pattern, and a signal line by selectively making the insulating layer, the semiconductor layer, and the conductive layer subject to patterning by photolithography and etching processes.

The first anode AE1 and the first preliminary sacrificial pattern SP1-I may be formed by the same patterning process, the second anode AE2 and the second preliminary sacrificial pattern SP2-I and the third anode AE3 and the third preliminary sacrificial pattern SP3-I may be formed by the same patterning process. The pixel defining layer PDL may be disposed over the base layer BL. The pixel defining layer PDL may cover each of the first, second and third anodes AE1, AE2 and AE3 and the first, second and third preliminary sacrificial patterns SP1-I, SP2-I and SP-3I.

The first preliminary barrier wall layer L1-I may be disposed on the pixel defining layer PDL. The first preliminary barrier wall layer L1-I may be formed by a process of depositing a conductive material on the underlying stacked structure (e.g., PDL to BL, inclusive). The second preliminary barrier wall layer L2-I may be disposed on the first preliminary barrier wall layer L1-I. The second preliminary barrier wall layer L2-I may also be formed by a process of depositing a conductive material. In this embodiment, the first preliminary barrier wall layer L1-I may include aluminum (Al) or molybdenum (Mo), and the second preliminary barrier wall layer L2-I may include titanium (Ti). However, the materials of the first preliminary barrier wall layer L1-I and the second preliminary barrier wall layer L2-I are not limited thereto. The first preliminary barrier wall layer L1-I and the second preliminary barrier wall layer L2-I may form a preliminary barrier wall PW-I.

The method according to this embodiment may include forming a first photoresist layer PR1 on the preliminary barrier wall PW-I. The first photoresist layer PR1 may be formed by forming a preliminary photoresist layer on the preliminary barrier wall PW-I and thereafter making the preliminary photoresist layer subject to patterning using a photo mask. A first photo opening OP-PR1, a second photo opening OP-PR2, a third photo opening OP-PR3, and a fourth photo opening OP-PR4 may be formed in the first photoresist layer PR1 through the patterning process. The first photo opening OP-PR1 may overlap the first anode AE1, the second photo opening OP-PR2 may overlap the second anode AE2, and the third photo opening OP-PR3 may overlap the third anode AE3. The fourth photo opening OP-PR4 may overlap or correspond to the first blocking opening OP-A1 (refer to FIG. 9) to be located between the first photo opening OP-PR1 and the second photo opening OP-PR2 in a direction along the circuit element layer DP-CL.

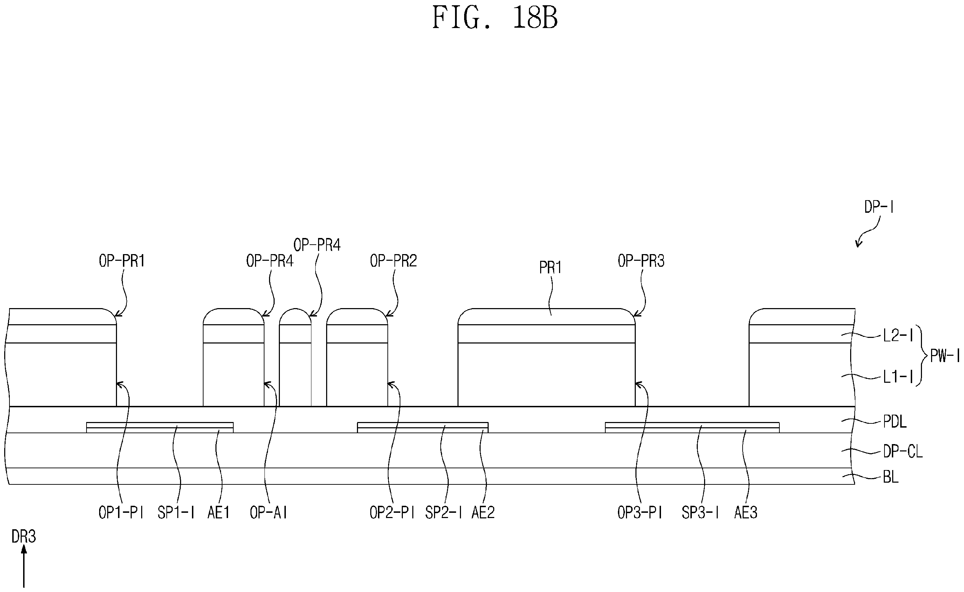

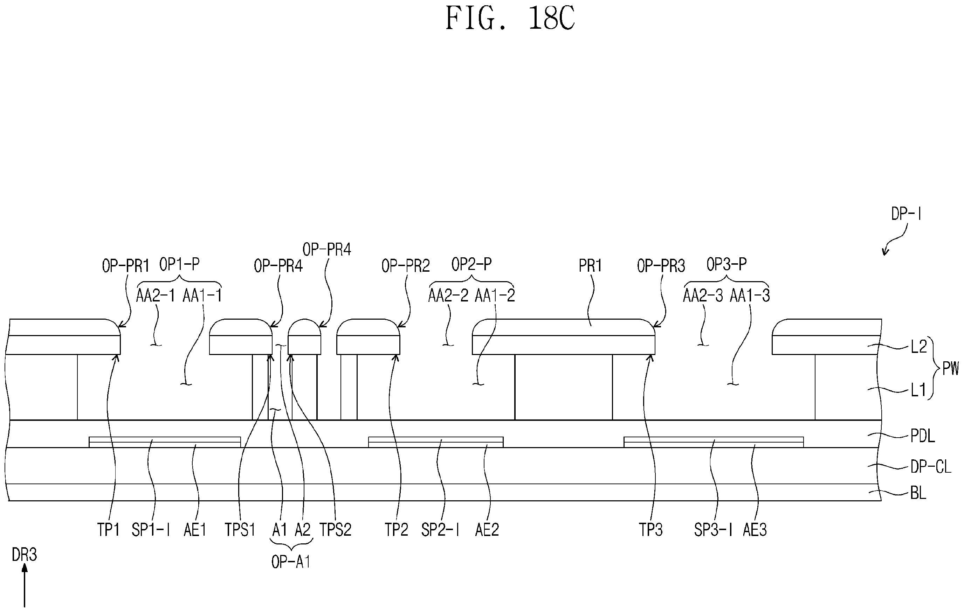

Referring to FIGS. 18B and 18C, the method according to this embodiment may include forming the first barrier wall layer L1 and the second barrier wall layer L2 having the barrier wall openings OP1-P, OP2-P, and OP3-P and the first blocking opening OP-A1 defined therein, by etching the first preliminary barrier wall layer L1-I and the second preliminary barrier wall layer L2-I such that the barrier wall PW is formed from the preliminary barrier wall PW-I. The barrier wall PW may include main barrier walls and a sub-barrier wall defined within a main barriers wall to define a gap of the blocking opening which is between the sub-barrier wall and the main barrier wall.

As illustrated in FIG. 18B, a process of firstly etching the first preliminary barrier wall layer L1-I and the second preliminary barrier wall layer L2-I may include forming preliminary barrier wall openings OP1-PI, OP2-PI, and OP3-PI and a preliminary first blocking opening OP-AI in the preliminary barrier wall PW-I, by dry etching the first preliminary barrier wall layer L1-I and the second preliminary barrier wall layer L2-I using the first photoresist layer PR1 as a mask.

The preliminary barrier wall openings OP1-PI, OP2-PI, and OP3-PI may include the first preliminary barrier wall opening OP1-PI, the second preliminary barrier wall opening OP2-PI, and the third preliminary barrier wall opening OP3-PI. The first preliminary barrier wall opening OP1-PI may be formed to overlap the first anode AE1, the second preliminary barrier wall opening OP2-PI may be formed to overlap the second anode AE2, and the third preliminary barrier wall opening OP3-PI may be formed to overlap the third anode AE3.

The first dry etching process in this embodiment may be performed in an etching environment in which the etch selectivity between the first preliminary barrier wall layer L1-I and the second preliminary barrier wall layer L2-I is substantially the same. Accordingly, the inner surfaces of the first preliminary barrier wall layer L1-I and the inner surfaces of the second preliminary barrier wall layer L2-I which define the preliminary barrier wall openings OP1-PI, OP2-PI, and OP3-PI and the preliminary first blocking opening OP-A1 may be substantially aligned with each other.

As illustrated in FIG. 18C, secondly etching the first preliminary barrier wall layer L1-I (refer to FIG. 18B) may include forming the barrier wall openings OP1-P, OP2-P and OP3-P from the preliminary barrier wall openings OP1-PI, OP2-PI, and OP3-PI (refer to FIG. 18B) and forming the first blocking opening OP-A1 from the preliminary first blocking opening OP-AI, by wet etching the first preliminary barrier wall layer LI-I exposed to the various preliminary openings, using the first photoresist layer PR1 as a mask.

The barrier wall openings OP1-P, OP2-P, and OP3-P may include the first barrier wall opening OP1-P, the second barrier wall opening OP2-P, and the third barrier wall opening OP3-P. The first barrier wall opening OP1-P may be formed to overlap the first anode AE1, the second barrier wall opening OP2-P may be formed to overlap the second anode AE2, and the third barrier wall opening OP3-P may be formed to overlap the third anode AE3.

The barrier wall openings OP1-P, OP2-P, and OP3-P may include the first regions AA1-1, AA1-2, and AA1-3 and the second regions AA2-1, AA2-2, and AA2-3 sequentially disposed in the thickness direction (that is, the third direction DR3), respectively. The first barrier wall layer L1 may include the first inner surfaces S-L1 which define the first regions AA1-1, AA1-2, and AA1-3 of the barrier wall openings OP1-P, OP2-P, and OP3-P and the third inner surfaces S-L3 which define the first opening portion A1 of the first blocking opening OP-A1, and the second barrier wall layer L2 may include the second inner surfaces S-L2 which define the second regions AA2-1, AA2-2, and AA2-3 of the barrier wall openings OP1-P, OP2-P, and OP3-P and the fourth inner surfaces S-L4 which define the second opening portion A2 of the first blocking opening OP-A1.

Referring to FIGS. 9 and 18C, the forming the first barrier wall layer L1 and the second barrier wall layer L2 may include forming, in the second barrier wall layer L2, the tip portions TP protruding toward the barrier wall openings OP1-P, OP2-P, and OP3-P with respect to the sidewall of the first barrier wall layer L1. First, second and third tip portions TP1, TP2 and TP3 are provided at the barrier wall openings OP1-P, OP2-P, and OP3-P, respectively.

In addition, the forming the first barrier wall layer L1 and the second barrier wall layer L2 may include forming, in the second barrier wall layer L2, the blocking tip portions TPS1 and TPS2 protruding toward the first blocking opening OP-A1 with respect to the main barrier wall and the sub-barrier wall of the first barrier wall layer L1. The second wet etching process in this embodiment may be performed in an environment in which the etch selectivity between the first preliminary barrier wall layer L1-I and the second preliminary barrier wall layer L2-I (refer to FIG. 18B) is large. Accordingly, the inner surfaces of the barrier wall PW which define the barrier wall openings OP1-P, OP2-P, and OP3-P and the first blocking opening OP-A1 may have an undercut shape on the section. Specifically, since the etch rate of the first barrier wall layer L1 by an etching solution is higher than the etch rate of the second barrier wall layer L2 by the etching solution, the first barrier wall layer L1 may be mainly etched during the second etching process. Accordingly, the first inner surfaces S-L1 of the first barrier wall layer L1 may be recessed inward when compared to the second inner surfaces S-L2 of the second barrier wall layer L2, at both the main barrier wall openings (e.g., the barrier wall openings OP1-P, OP2-P, and OP3-P) and the sub-barrier wall openings (e.g., the first blocking opening OP-A1). The tip portions TP exposed to the main barrier wall openings and the blocking tip portions TPS1 and TPS2 exposed to the sub-barrier wall openings, may be formed in the barrier wall PW by the extended portions of the second barrier wall layer L2 which protrude further than a sidewall off the first barrier wall layer L1 at the respective barrier wall openings.

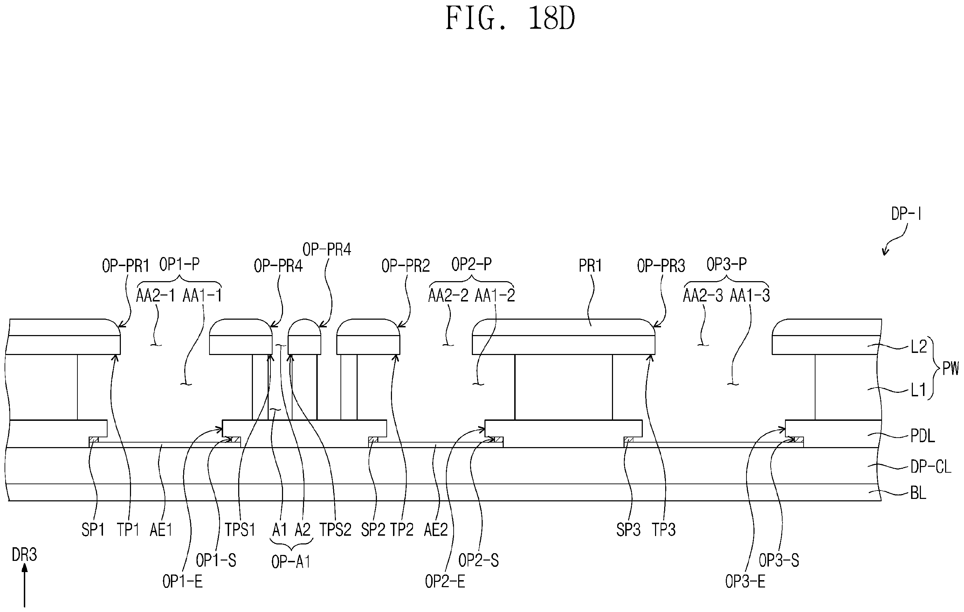

Referring to FIG. 18D, the method according to this embodiment may include etching the pixel defining layer PDL and etching the preliminary sacrificial patterns SP1-I, SP2-I and SP-3I (refer to FIG. 18C). The process of etching the pixel defining layer PDL may be performed by a dry etching method and may be performed using the first photoresist layer PR1 and the barrier wall PW (e.g., the second barrier wall layer L2) as a mask. The light emitting openings OP1-E, OP2-E, and OP3-E corresponding to the barrier wall openings OP1-P, OP2-P, and OP3-P may be formed in the pixel defining layer PDL. The light emitting openings OP1-E, OP2-E, and OP3-E may include the first light emitting opening OP1-E, the second light emitting opening OP2-E, and the third light emitting opening OP3-E.

The process of etching the preliminary sacrificial patterns SP1-I, SP2-I, and SP3-I may be performed by a wet etching method. The sacrificial openings OP1-S, OP2-S, and OP3-S overlapping the light emitting openings OP1-E, OP2-E, and OP3-E may be formed in the sacrificial patterns SP1, SP2, and SP3 formed by etching the preliminary sacrificial patterns SP1-I, SP2-I, and SP3-I.

The first sacrificial opening OP1-S overlapping the first light emitting opening OP1-E may be formed in the first sacrificial pattern SP1, the second sacrificial opening OP2-S overlapping the second light emitting opening OP2-E may be formed in the second sacrificial pattern SP2, and the third sacrificial opening OP3-S overlapping the third light emitting opening OP3-E may be formed in the third sacrificial pattern SP3.

The etching process of the sacrificial patterns SP1, SP2, and SP3 may be performed in an environment in which the etch selectivity between the sacrificial patterns SP1, SP2, and SP3 and the anodes AE1, AE2, and AE3 is large. Accordingly, the anodes AE1, AE2, and AE3 may be prevented from being etched together with the the sacrificial patterns SP1, SP2, and SP3.

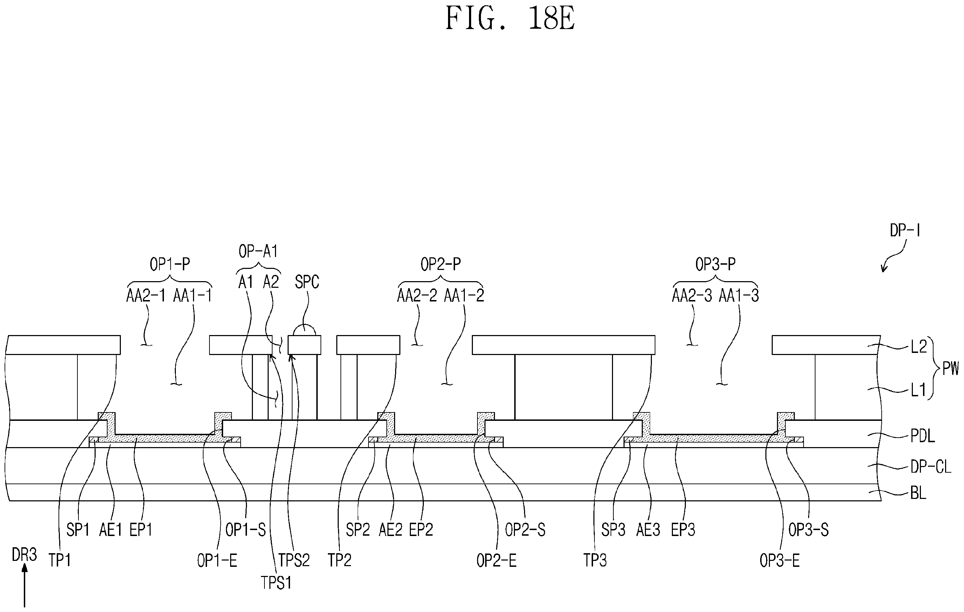

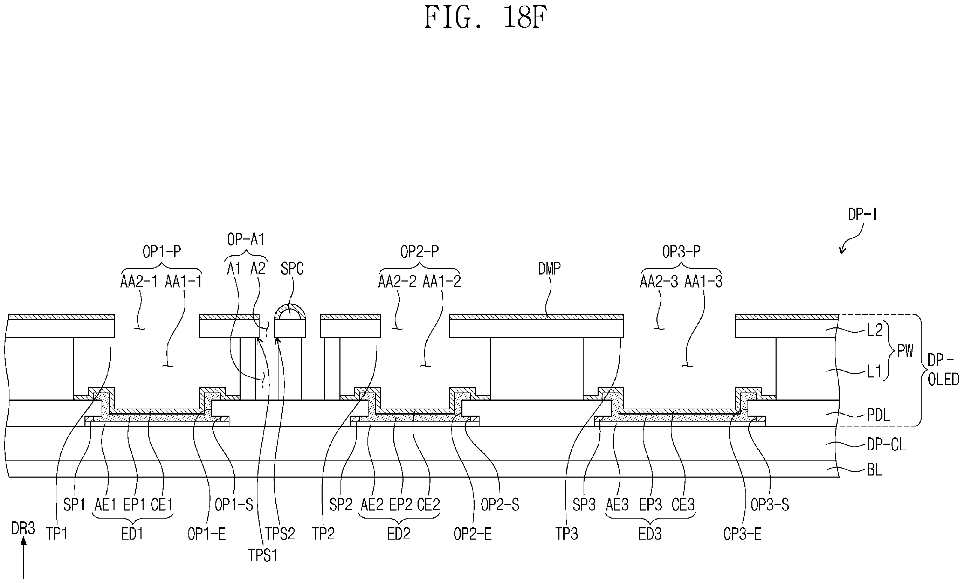

Referring to FIGS. 18E and 18F, the method according to this embodiment may include forming the first to third emission patterns EP1, EP2, and EP3 and the first to third cathodes CE1, CE2, and CE3 in the barrier wall openings OP1-P, OP2-P, and OP3-P, respectively, after removing the first photoresist layer PR1 (refer to FIG. 18D).

Referring to FIG. 18E, the spacer SPC disposed on the second barrier wall layer L2 at the sub-barrier wall may be formed. The spacer SPC may be formed through a patterning process after an organic material is applied to the second barrier wall layer L2. Fine metal masks may be used when the first to third emission patterns EP1, EP2, and EP3 are formed. The first to third emission patterns EP1, EP2 and EP3 are in a same layer as each other. As being in a same layer, elements may be formed in a same process and/or include a same material as each other, elements may be respective portions of a same material layer, elements may be on a same layer by forming an interface with a same underlying or overlying layer, etc., without being limited thereto.

When the first emission pattern EP1 is formed, patterning may be performed using a first mask having a mask opening corresponding to the first emissive region PXA-R (refer to FIG. 9). When the second emission pattern EP2 is formed, patterning may be performed using a second mask having a mask opening corresponding to the second emissive region PXA-G (refer to FIG. 9). When the third emission pattern EP3 is formed, patterning may be performed using a third mask having a mask opening corresponding to the third emissive region PXA-B (refer to FIG. 9). In this case, the spacer SPC may support the first to third masks.

The spacer SPC may be damaged by foreign matter remaining on the spacer SPC after the patterning process of the first to third emission patterns EP1, EP2, and EP3 and/or dents in the fine metal masks. Accordingly, foreign matter may be easily introduced into a portion adjacent to the spacer SPC. However, since the first blocking opening OP-A1 surrounds the spacer SPC when viewed from above the plane, foreign matter or moisture introduced through the portion adjacent to the spacer SPC may not be able to be introduced into the first to third emission patterns EP1, EP2, and EP3 and the first to third cathodes CE1, CE2, and CE3 (refer to FIG. 18F).

Referring to FIG. 18F, the first to third cathodes CE1, CE2, and CE3 may be formed using an open mask. In forming the first to third cathodes CE1, CE2, and CE3, the dummy pattern DMP disposed on the second barrier wall layer L2 at each of the main barrier walls and sub-barrier walls may be simultaneously formed. A material layer for forming the first to third cathodes CE1, CE2, and CE3 may be separated from the dummy pattern DMP by the barrier wall PW, owing to the tip structure thereof. The first to third cathodes CE1, CE2, and CE3 may be disposed in the barrier wall openings OP1-P, OP2-P, and OP3-P, respectively. The first to third cathodes CE1, CE2, and CE3 and the various patterns of a dummy pattern layer on an upper surface of the main barrier walls and the sub-barrier walls, may be in a same layer as each other.

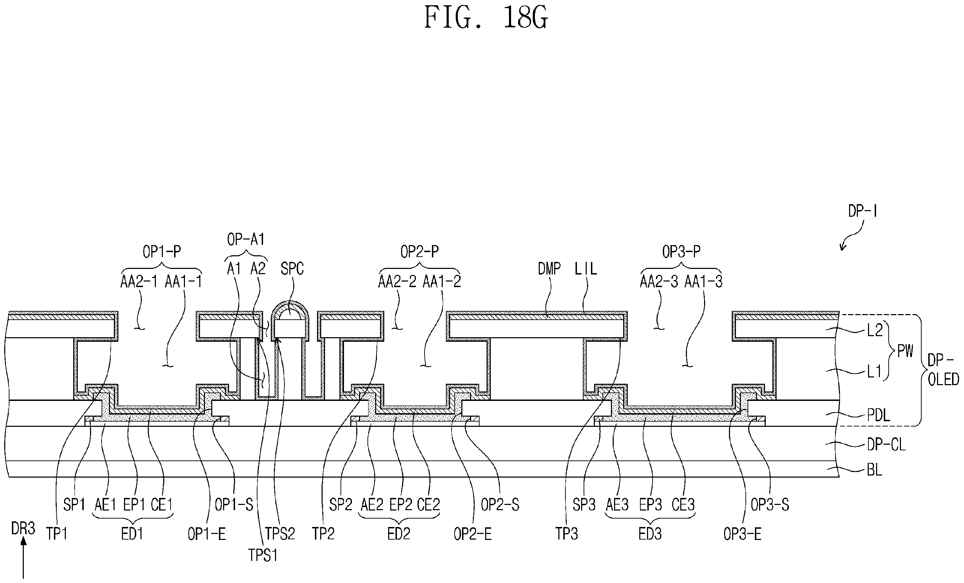

Referring to FIG. 18G, the method according to this embodiment may include the lower inorganic encapsulation layer LIL. The lower inorganic encapsulation layer LIL may be formed through a deposition process. In an embodiment, the lower inorganic encapsulation layer LIL may be formed through a chemical vapor deposition (CVD) process. The lower inorganic encapsulation layer LIL may be formed on the barrier wall PW, along both main barrier walls and sub-barrier walls, such that portions of the lower inorganic encapsulation layer LIL may be formed in the barrier wall openings OP1-P, OP2-P, and OP3-P and the first blocking opening OP-A1. The lower inorganic encapsulation layer LIL may cover the first to third light emitting elements ED1, ED2, and ED3.

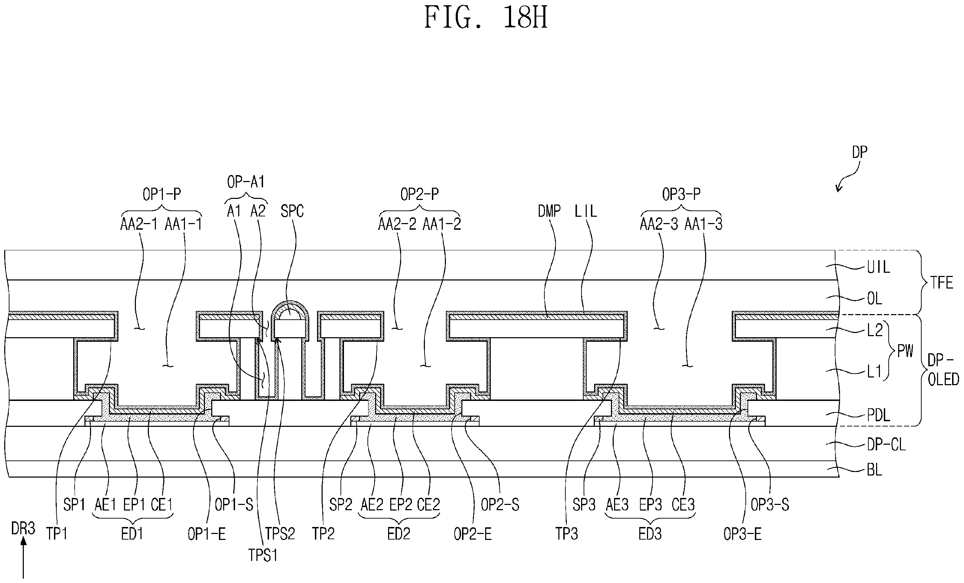

Referring to FIG. 18H, the method according to this embodiment may include forming the organic encapsulation film OL and the upper inorganic encapsulation layer UIL to complete the display panel DP. The organic encapsulation film OL may be formed by applying an organic material using an inkjet method, but is not limited thereto. The organic encapsulation film OL may include an organic material which has a permittivity of about 2.0 to about 3.2 and which is able to be subjected to a photolithography process. The organic encapsulation film OL provides a flat upper surface. The upper inorganic encapsulation layer UIL may be formed by depositing an inorganic material. Accordingly, the display panel DP including the base layer BL, the circuit element layer DP-CL, the display element layer DP-OLED, and the thin film encapsulation layer TFE may be formed.

As described above, the display device DD according to the present disclosure may include the blocking opening OP-A1 surrounding a sub-barrier wall and the spacer SPC thereon. At the blocking opening OP-A1 defined in the second barrier wall layer L2, the blocking tip portions TPS protrude toward the blocking opening OP-A1. Accordingly, contaminants due to a dent in the spacer SPC or moisture may be prevented from moving to the light emitting elements, and thus a defect in the display device DD may be prevented.

In addition, the display device DD according to the present disclosure may include, in the thin film encapsulation layer TFE, the organic encapsulation film OL which is thin and has a low permittivity. Accordingly, the touch sensitivity of the input sensor INS which is on the organic encapsulation film OL may be improved.

In an embodiment, for example, the display device DD includes a pixel defining layer PDL including a light emitting opening defined therein, a barrier wall layer (all of the patterns of the first barrier wall layer L1 together with all the patterns of the second barrier wall layer L2 (and if applicable all the patterns of the third and fourth barrier wall layers L3 and L4) on the pixel defining layer PDL, the barrier wall layer including barrier walls (those patterns of various layers L1, L2, L3 and L4) spaced apart from each other and defining a barrier wall opening of the barrier wall layer which is between the barrier walls, the barrier wall opening overlapping the light emitting opening of the pixel defining layer PDL, a light emitting element ED overlapping the light emitting opening of the pixel defining layer PDL, and a spacer SPC which is on a barrier wall among the barrier walls and spaced apart from the light emitting opening and the barrier wall opening. The barrier wall which has the spacer SPC thereon defines a blocking opening of the barrier wall which surrounds the spacer SPC.

In an embodiment, for example, the display device DD includes a base layer including a display region DA including a light emissive region PXA and a non-emissive region NPXA, a non-display region NDA adjacent to the display region DA, a barrier wall layer on the base layer, the barrier wall layer including barrier walls spaced apart from each other and defining a barrier wall opening corresponding to the light emissive region PXA, a light emitting element ED overlapping the light emissive region, and a spacer SPC which is on a barrier wall among the barrier walls and overlaps the non-emissive region of the display region. The barrier wall which has the spacer SPC thereon defines a blocking opening of the barrier wall which is between the spacer and the light emitting element.

While the present disclosure has been described with reference to embodiments thereof, it will be apparent to those of ordinary skill in the art that various changes and modifications may be made thereto without departing from the scope of the present disclosure as set forth in the following claims.

## Claims

1. A display device comprising:
a pixel defining layer (PDL) including a light emitting opening (OP-E) defined therein;
a barrier wall layer on the pixel defining layer, the barrier wall layer comprising barrier walls (PW) spaced apart from one another and defining a barrier wall opening (OP-P) of the barrier wall layer defined between two barrier walls disposed next to each other, the barrier wall opening (OP-P) overlapping the light emitting opening (OP-E) of the pixel defining layer;
a light emitting element (ED1, ED2, ED3) overlapping the light emitting opening of the pixel defining layer; and
a spacer (SPC) disposed on a barrier wall among the barrier walls and spaced apart from the light emitting opening and the barrier wall opening,
wherein the barrier wall including the spacer thereon defines a blocking opening (OP-A1) of the barrier wall surrounding the spacer.

2. The display device of claim 1, wherein each of the barrier walls (PW) comprises:
a first barrier wall layer (L1) and a second barrier wall layer (L2) which is on the first barrier wall layer, and
at the blocking opening, the second barrier wall layer (L2) protruding further than the first barrier wall layer and defining a first blocking tip portion (TPS1) at the second barrier wall layer.

3. The display device of claim 2, wherein the blocking opening (OP-A1) includes:
a first opening portion (A1) defined in the first barrier wall layer,
a second opening portion (A2) defined in the second barrier wall layer, and
wherein a width of the first opening portion is greater than a width of the second opening portion.

4. The display device of claim 3, wherein the width of the second opening (A2) portion is equal to or greater than 0.1 micrometer.

5. The display device of claim 3 or 4, wherein the width of the second opening portion (A2) is equal to or less than 1 micrometer.

6. The display device of any of the preceding claims, wherein
an inner surface of the barrier wall layer defines the barrier wall opening (OP-P),
the light emitting element (ED1, ED2, ED3) includes a first electrode (ED1), an emission pattern on the first electrode, and a second electrode (ED2) on the emission pattern, and
the second electrode contacts the inner surface of the barrier wall layer at the barrier wall opening.

7. The display device of any of the preceding claims, further comprising:
an encapsulation layer (TFE) on the light emitting element and covering the light emitting element,
wherein the encapsulation layer (TFE) includes:
a lower inorganic encapsulation layer (LIL) on the light emitting element and covering the light emitting element and the barrier walls (PW);
an organic encapsulation film (OL) on the lower inorganic encapsulation layer; and
an upper inorganic encapsulation layer (UIL) on the organic encapsulation film.

8. The display device of claim 7, wherein
an inner surface of the barrier wall layer defines the blocking opening,
the lower inorganic encapsulation layer (LIL) extends along the inner surface of the barrier wall layer which defines the blocking opening, and
the organic encapsulation film (OL) extends along the lower inorganic encapsulation layer and into the blocking opening.

9. The display device of claim 7 or 8, wherein
the blocking opening is open to outside the barrier wall layer at an inlet,
the lower inorganic encapsulation layer (OL) extends across the inlet and covers and seals the blocking opening, and
the blocking opening (OP-A1) which is sealed by the lower inorganic encapsulation layer is filled with air.

10. The display device of claim 7, wherein the barrier wall layer comprises :
a first barrier wall which has the spacer thereon and defines the blocking opening (OP-A1),
a second barrier wall defining an opening of the second barrier wall which is spaced apart from both the light emitting opening and the blocking opening and is open to outside the barrier wall layer at an inlet,
the lower inorganic encapsulation layer extends across the inlet and covers and seals the opening, and
the opening which is sealed by the lower inorganic encapsulation layer is filled with air.

11. The display device of any of claims 7 to 10, wherein the organic encapsulation film (OL) of the encapsulation layer has a thickness of equal to or greater than 0.1 micrometer and equal to or less than 20 micrometers.

12. The display device of any of claims 7 to 11, wherein the organic encapsulation film (OL) of the encapsulation layer has a permittivity of equal to or greater than 2.0 and equal to or less than 3.2.

13. The display device of any of claims 7 to 12, further comprising:
an input sensor directly on the encapsulation layer,
wherein the input sensor (INS) includes:
a sensor base layer (IS-IL1) directly on the encapsulation layer;
a first sensor conductive layer (IS-CL1) on the sensor base layer;
a sensor insulating layer (IS-IL2) on the first sensor conductive layer and covering the first sensor conductive layer; and
a second sensor conductive layer (IS-CL21) on the sensor insulating layer.

14. The display device of any of the preceding claims, wherein the barrier wall layer comprises:
a first barrier wall layer, a second barrier wall layer, a third barrier wall layer and a fourth barrier wall layer in the order from the pixel defining layer, and
the first barrier wall layer, the second barrier wall layer, the third barrier wall layer and the fourth barrier wall layer define the blocking opening which surrounds the spacer.

15. The display device of claim 14, wherein at the blocking opening,
the second barrier wall layer protrudes further than the first barrier wall layer and defines a first blocking tip portion at the second barrier wall layer, and
the fourth barrier wall layer protrudes further than the third barrier wall layer and defines a second blocking tip portion at the fourth barrier wall layer.
